(19) Europäisches Patentamt
European Patent Office
Office européen des brevets

(11) **EP 3 174 004 A1**

(12) **EUROPEAN PATENT APPLICATION**
published in accordance with Art. 153(4) EPC

(43) Date of publication:
**31.05.2017 Bulletin 2017/22**

(51) Int Cl.:
*G06Q 50/06* (2012.01)　　*G01R 21/00* (2006.01)
*G06Q 10/00* (2012.01)　　*H02J 13/00* (2006.01)

(21) Application number: **15824919.3**

(22) Date of filing: **10.07.2015**

(86) International application number:
**PCT/JP2015/069828**

(87) International publication number:
**WO 2016/013411 (28.01.2016 Gazette 2016/04)**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**MA**

(30) Priority: **25.07.2014　JP 2014152407**

(71) Applicant: **Sony Corporation**
**Tokyo 108-0075 (JP)**

(72) Inventors:
• **TAKADA Masayuki**
**Tokyo 108-0075 (JP)**
• **DOI Shouichi**
**Tokyo 108-0075 (JP)**
• **MORITA Masahiro**
**Tokyo 108-0075 (JP)**
• **TAKEOKA Yoshiki**
**Tokyo 108-0075 (JP)**
• **KURATA Yoshinori**
**Tokyo 108-0075 (JP)**
• **ISHIHARA Atsushi**
**Tokyo 108-0075 (JP)**
• **CHATANI Masayuki**
**Tokyo 108-0075 (JP)**

(74) Representative: **Witte, Weller & Partner**
**Patentanwälte mbB**
**Postfach 10 54 62**
**70047 Stuttgart (DE)**

(54) **CONTROL DEVICE, CONTROL METHOD, INFORMATION PROCESSING DEVICE, INFORMATION PROCESSING METHOD, AND PROGRAM**

(57)　The present technology relates to a control apparatus, a control method, an information processing apparatus, an information processing method, and a program, by which disaggregation of determining power consumption or the like of each of a plurality of appliances in a house or the like can be rapidly performed.

A control apparatus such as an agent operates an appliance, recognizes an operation state of the appliance, and sends an appliance label indicating the appliance and an operation state label indicating the operation state of the appliance. An information processing apparatus such as a disaggregation apparatus acquires, from the control apparatus, the appliance label and the operation state label. In addition, the information processing apparatus acquires possibility information resulting from disaggregation of separating current consumption of the appliances. The possibility information indicates a possibility that current consumption indicated by the pattern information is being consumed in the appliance. The information processing apparatus determines, on the basis of the possibility information, pattern information indicating current consumption in a current operation state of the appliance, and performs labeling of associating the appliance label and the operation state label with the pattern information. The present technology is applicable to disaggregation of separation current consumption of appliances, for example.

FIG.1

EP 3 174 004 A1

**Description**

Technical Field

The present technology relates to a control apparatus, a control method, an information processing apparatus, an information processing method, and a program, and in particular to a control apparatus, a control method, an information processing apparatus, an information processing method, and a program, by which disaggregation of determining power consumption or the like of a plurality of appliances in a house, for example, can be rapidly performed.

Background Art

A technology called NILM (Non-Intrusive Load Monitoring) has attracted attention. In this technology, on the basis of information of currents measured by a distribution board (switchboard) in a house, for example, individual power consumption, current consumption, and the like of appliances (electric apparatuses, electronic apparatuses) such as major appliances (home electric appliances) in the house, which are connected thereto, are determined.

The applicant of the subject application has already proposed a disaggregation technology as the NILM. In this technology, using an FHMM (Factorial Hidden Markov Model), current consumption or the like of each of not only appliances each having two operation states, which are only ON and OFF, but also appliances each having three or more operation states, is easily and accurately determined on the basis of information on currents measured by a distribution board (e.g., see Patent Document 1).

Patent Document 1: Japanese Patent Application Laid-open No. 2013-210755

Summary

Problem to be solved

In order to perform disaggregation of determining current consumption or the like of the appliances on the basis of the information of currents measured by the distribution board, current consumption of each appliance has to vary in accordance with changes in the operation state of the appliance, i.e., the ON/OFF of the appliance, for example.

The operation state of the appliance can be changed by a user's operation, for example. However, with the user's operation, it takes time to perform disaggregation.

The present technology has been made in view of the above-mentioned circumstances to rapidly perform disaggregation.

Means for solving the Problem

An information processing apparatus or a first program according to the present technology is an information processing apparatus including: an appliance information acquisition unit that acquires an appliance label and an operation state label from a control apparatus that operates an appliance, recognizes an operation state of the appliance, and sends the appliance label indicating the appliance and the operation state label indicating the operation state of the appliance; a possibility information acquisition unit that updates pattern information on the basis of possibility information indicating a possibility that current consumption indicated by the pattern information is being consumed, which is obtained with respect to the pattern information indicating the current consumption in each of operation states of each of a plurality of appliances, using total sum data on a total sum of currents consumed by the appliances, to thereby acquire the possibility information resulting from disaggregation of separating current consumption of the appliances; and a labeling unit that determines, on the basis of the possibility information, pattern information indicating current consumption consumed in a current operation state of the appliance indicated by the appliance label, and performs labeling of associating the appliance label and the operation state label with the pattern information. Alternatively, it is a program for causing a computer to function as such an information processing apparatus.

An information processing method according to the present technology is information processing method including the steps of: acquiring an appliance label and an operation state label from a control apparatus that operates an appliance, recognizes an operation state of the appliance, and sends the appliance label indicating the appliance and the operation state label indicating the operation state of the appliance; updating pattern information, using total sum data on a total sum of currents consumed by a plurality of appliances, on the basis of possibility information indicating a possibility that current consumption indicated by the pattern information is being consumed, which is obtained with respect to the pattern information indicating current consumption in each of operation states of each of the appliances, to thereby acquire the possibility information resulting from disaggregation of separating current consumption of the appliances; and determining, on the basis of the possibility information, pattern information indicating current consumption consumed in a current operation state of the appliance indicated by the appliance label and performing labeling in which the appliance label with the operation state label are associated with the pattern information.

In the information processing apparatus, the information processing method, and the first program according to the present technology, an appliance label and an operation state label are acquired from a control apparatus that operates an appliance, recognizes an operation state of the appliance, and sends the appliance label indicating the appliance and the operation state label indicating the operation state of the appliance. Further, pattern information is updated on the basis of possibility information indicating a possibility that current consumption indicated by the pattern information is being consumed, which is obtained with respect to the pattern information indicating current consumption in each of operation states of each of a plurality of appliances, using total sum data on a total sum of currents consumed by the appliances, to thereby acquire the possibility information resulting from the disaggregation of separating current consumption of the appliances. In addition, pattern information indicating current consumption consumed in a current operation state of the appliance indicated by the appliance label is determined on the basis of the possibility information, and labeling in which the appliance label and the operation state label are associated with the pattern information is performed.

A control apparatus or a second program according to the present technology is a control apparatus including: an operation controller that controls an operation with respect to an appliance; a recognition unit that recognizes an operation state of the appliance; and a communication unit that updates pattern information on the basis of possibility information indicating a possibility that current consumption indicated by the pattern information is being consumed, which is obtained with respect to the pattern information indicating current consumption in each of operation states of each of a plurality of appliances, using total sum data on a total sum of currents consumed by the appliances, to thereby send, to a disaggregation apparatus that performs disaggregation of separating current consumption of the appliances, an appliance label indicating the appliance and an operation state label indicating the operation state of the appliance. Alternatively, it is a program for causing a computer to function as such an control apparatus.

A control method according to the present technology is a control method including the steps of: operating an appliance; recognizing an operation state of the appliance; and updating pattern information, using total sum data on a total sum of currents consumed by a plurality of appliances, on the basis of possibility information indicating a possibility that current consumption indicated by the pattern information is being consumed, which is obtained with respect to the pattern information indicating current consumption in each of operation states of each of the appliances, to thereby send, to a disaggregation apparatus that performs disaggregation of separating current consumption of the appliances, an appliance label indicating the appliance and an operation state label indicating the operation state of the appliance.

In the control apparatus, the control method, and the second program according to the present technology, an appliance is operated and an operation state of the appliance is recognized. Further, pattern information is updated using total sum data on a total sum of currents consumed by a plurality of appliances, on the basis of possibility information indicating a possibility that current consumption indicated by the pattern information is being consumed, which is obtained with respect to the pattern information indicating current consumption in each of operation states of each of the appliances, to thereby send, to a disaggregation apparatus that performs disaggregation of separating current consumption of the appliances, an appliance label indicating the appliance and an operation state label indicating the operation state of the appliance.

Note that the information processing apparatus and the control apparatus may be independent apparatuses or may be internal blocks that configure a single apparatus.

Further, the program can be provided by being transmitted via a transmission medium or recorded on a recording medium.

Effects

In accordance with the present technology, it is possible to rapidly perform disaggregation.

It should be noted that the effects described here are not necessarily limitative and may be any effect described in the present disclosure.

Brief Description of Drawings

[Fig. 1] A diagram showing a configuration example of an embodiment of a disaggregation system to which the present technology is applied.
[Fig. 2] A diagram describing an example of processing of the disaggregation system.
[Fig. 3] A diagram describing the outline of the disaggregation performed by a disaggregation apparatus 16.
[Fig. 4] A diagram describing the outline of waveform separation learning performed in the disaggregation.

[Fig. 5] A block showing a configuration example of the disaggregation apparatus 16.

[Fig. 6] A diagram describing an FHMM.

[Fig. 7] A diagram describing the outline of formulation of the disaggregation by the FHMM.

[Fig. 8] A flowchart describing processing of learning (learning processing) of the FHMM according to an EM algorithm, which is performed by the disaggregation apparatus 16.

[Fig. 9] A flowchart describing processing of an E step, which is performed by the disaggregation apparatus 16 in Step S13.

[Fig. 10] A diagram describing a relationship between forward probability $\alpha_{t,z}$ and backward probability $\beta_{t,z}$ of an FHMM and forward probability $\alpha_{t,i}$ and backward probability $\beta_{t,j}$ of an HMM.

[Fig. 11] A flowchart describing processing of an M step, which is performed by the disaggregation apparatus 16 in Step S14.

[Fig. 12] A flowchart describing information presentation processing of presenting information of an appliance #m, which is performed by the disaggregation apparatus 16.

[Fig. 13] A diagram showing a display example of power consumption $U^{(m)}$, which is performed in the information presentation processing.

[Fig. 14] A perspective view showing an external configuration example of an agent 14.

[Fig. 15] A block diagram showing an internal configuration example of the agent 14.

[Fig. 16] A diagram showing an example of an appliance table stored in a semiconductor memory 115.

[Fig. 17] A block diagram showing a configuration example of a label acquisition unit 35 when the agent 14 and the disaggregation apparatus 16 cooperatively operate.

[Fig. 18] A diagram showing an example of a correspondence table stored in a correspondence storage unit 204.

[Fig. 19] A flowchart showing an example of processing performed by the agent 14 as labeling processing for registering correspondence information in the correspondence table.

[Fig. 20] A flowchart showing an example of processing performed by the label acquisition unit 35 as labeling processing for registering the correspondence information in the correspondence table.

[Fig. 21] A block diagram showing a configuration example of the data output unit 36 when the agent 14 and the disaggregation apparatus 16 cooperatively operate.

[Fig. 22] A flowchart showing an example of processing performed by the agent 14 as operation state notification processing of notifying a user of an operation state of an appliance of a user's house.

[Fig. 23] A flowchart showing an example of processing performed by a data output unit 36 as the operation state notification processing of notifying the user of the operation states of the appliances of the user's house.

[Fig. 24] A block diagram showing a configuration example of hardware according to an embodiment of a computer to which the present technology is applied.

Description of Preferred Embodiments

<Configuration Example of Disaggregation System>

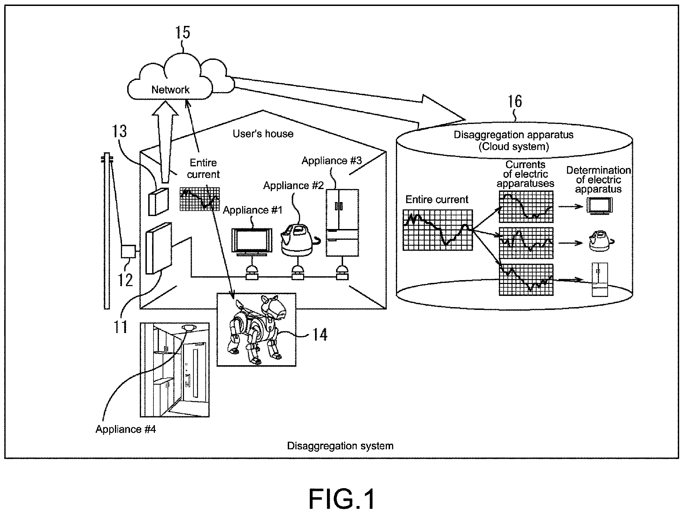

Fig. 1 is a diagram showing a configuration example of an embodiment of a disaggregation system to which the present technology is applied.

In a user's house (home, company, etc.), a distribution board 11 is placed. Electricity provided from a power company passes through a wattmeter 12, is drawn in the distribution board 11, and supplied from the distribution board 11 to an appliance such as a major appliance (connected to outlet or the like) of the user's house.

A current sensor 13 is mounted on, for example, the distribution board 11. The current sensor 13 measures, at a so-called single base point of the distribution board 11, a total sum of currents consumed by all appliances (one or more appliances) in the user's house, the single base point supplying the user's house with electricity. Via a network 15 such as the Internet, the current sensor 13 sends it to the disaggregation apparatus 16 configured in the cloud, for example.

The agent 14 is a movable pet robot which looks like a dog, for example. The agent 14 functions as a control apparatus that controls the appliances of the user's house.

Specifically, the agent 14 moves the hands or legs, to thereby directly operate buttons of the appliances or remote controllers for the appliances. In this manner, the agent 14 operates the appliance, for example, powers ON/OFF the appliances or changing operation modes thereof.

Additionally, the agent 14 emits infrared rays similar to infrared rays emitted by the remote controllers for the appliances or wirelessly or wiredly communicates with the appliances via a home network. In this manner, the agent 14 can operate (control) the appliances.

Further, the agent 14 holds a stick or the like in a hand, for example, and operates the buttons of the appliances with the stick. In this manner, the agent 14 can operate the appliances.

The agent 14 recognizes operation states (e.g., ON/OFF states, mute states) of the appliances of the user's house. The agent 14 supplies them to the disaggregation apparatus 16 via the network 15, as appliance information on the appliances.

In addition, the agent 14 is capable of receiving the operation states of the appliances of the user's house from the disaggregation apparatus 16 via the network 15 and taking predetermined actions according to the operation states.

The disaggregation apparatus 16 receives a total sum of currents, which is sent from the current sensor 13 of the user's house via the network 15. The disaggregation apparatus 16 performs disaggregation of separating current consumption or power consumption consumed by the individual appliances of the user's house, for example, a TV (television receiver), an electric pot, a refrigerator, and a lamp, on the basis of a sequence of total sums of currents (current waveform sequence).

In addition, the disaggregation apparatus 16 performs labeling using the appliance information from the agent 14. The labeling is for indicating an appliance in which current consumption or the like resulting from the disaggregation is consumed and an operation state thereof.

Further, the disaggregation information 16 detects the operation states of the appliances of the user's house on the basis of current consumption or the like resulting from the disaggregation and sends them to the agent 14 via the network 15.

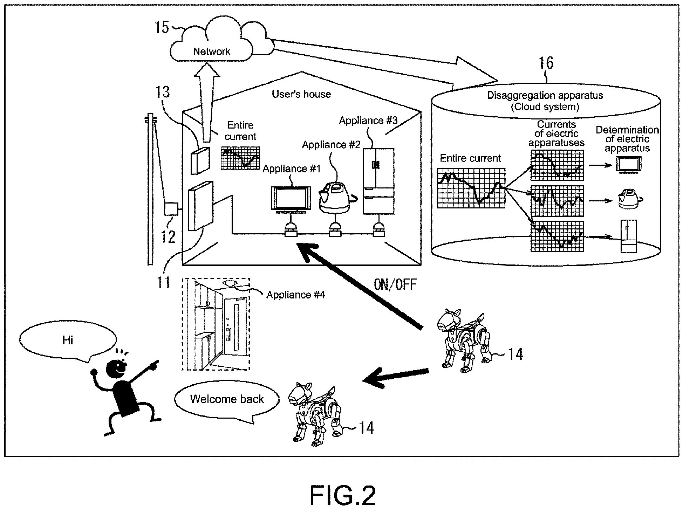

Fig. 2 is a diagram describing an example of processing of the disaggregation system of Fig. 1.

The current sensor 13 measures a total sum of currents consumed by all the appliances of the user's house. The current sensor 13 sends the total sum of currents to the disaggregation apparatus 16 via the network 15.

The disaggregation apparatus 16 receives the total sum of currents sent from the current sensor 13 of the user's house. The disaggregation apparatus 16 performs disaggregation. In the disaggregation, currents consumed by the individual appliances of the user's house are separated from a sequence of total sums of currents (current waveform sequence).

As shown in Figs. 1 and 2, there are appliances #1, #2, #3, #4 in the user's house. The disaggregation apparatus 16 performs disaggregation of separating currents (current consumption) individually consumed by the appliances #1 to #4 of the user's house.

Here, in order for the disaggregation apparatus 16 to separate the current consumption of the appliances #1 to #4, the current consumption of the appliances has to vary.

In view of this, the agent 14 of the user's house moves in the user's house if necessary and operates buttons of the appliances or remote controllers for the appliances, for example, to thereby operate the appliances, for example, powers ON/OFF the appliances.

With this, total sums of power consumption when the appliances #1 to #4 are in various operation states are sent from the current sensor 13 to the disaggregation apparatus 16. Examples of the total sums of power consumption include a total sum of current consumption of the appliances #1 to #4 when a certain appliance is powered OFF and a total sum of current consumption of the appliances #1 to #4 when another appliance is powered ON.

Then, the disaggregation apparatus 16 performs disaggregation using the total sums of power consumption when the appliances #1 to #4 are in the various operation states. With this, the current consumption of the appliances #1 to #4 is separated.

Further, the disaggregation apparatus 16 detects the operation states of the appliances of the user's house on the basis of current consumption of each of the appliances #1 to #4 resulting from the disaggregation. The disaggregation apparatus 16 sends them to the agent 14 via the network 15.

The agent 14 receives the operation states of the appliances of the user's house from the disaggregation apparatus 16. The agent 14 takes predetermined actions according to the operation states.

For example, it is assumed that the agent 14 receives, from the disaggregation apparatus 16, an operation states of an appliance, which indicates that a porch lamp of the user's house has been turned ON. In this case, the agent 14 recognizes that the porch lamp has been turned ON even when it is not located in an entrance of the user's house.

In this case, the agent 14 is capable of recognizing that the user who lives in the user's house comes back home, and taking an action of moving from a room of the user's house to the entrance to greet him or her.

Alternatively, the agent 14 is capable of notifying the user near a current location about the fact that the porch lamp of the user's house has been turned ON, as sound, for example.

<Disaggregation>

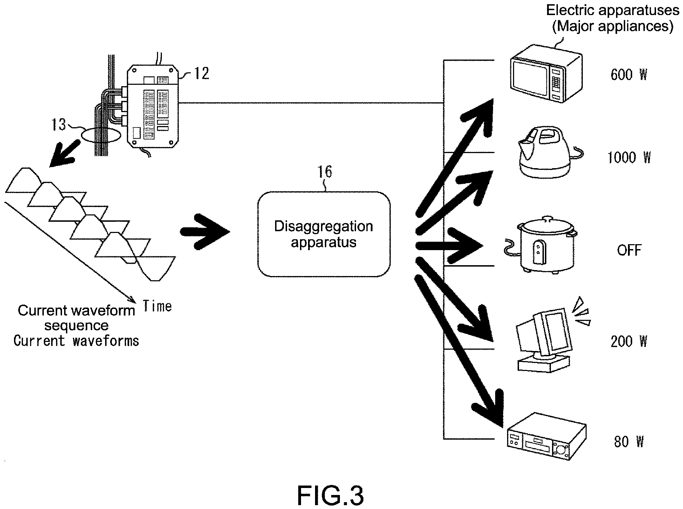

Fig. 3 is a diagram describing the outline of the disaggregation performed by the disaggregation apparatus 16 of Fig. 1.

In each user's house, electricity provided from a power company is drawn in a distribution board 12 and supplied from the distribution board 12 to appliances such as major appliances of the user's house.

For the disaggregation, the distribution board 12 is provided with the current sensor 13. The current sensor 13 measures a total sum of currents consumed by the appliances of the user's house. In this simple manner, current consumption (power consumption) of the individual appliances of the user's house is separated from a sequence of total sums of currents (current waveform sequence).

Note that total sum data on a total sum of currents consumed by the appliances, for example, simply, the total sum of currents consumed by the appliances can be employed as data used for disaggregation.

The total sum of values, which can be added, can be employed as the total sum data. Specifically, other than the total sum of currents consumed by the appliances themselves, a total sum of frequency components obtained by performing FFT (Fast Fourier Transform) or the like on the total sum of power consumed by the appliances or waveforms of currents consumed by the appliances can be, for example, employed as the total sum data.

Further, in the disaggregation, information on currents consumed by the individual appliances, such as currents consumed by the individual appliances can be separated on the basis of the total sum data. Specifically, in the disaggregation, currents and power values consumed by the individual appliances and frequency components thereof, for example, can be separated on the basis of the total sum data.

In the following description, it is assumed that the total sum of currents consumed by the appliances is, for example, employed as the total sum data and that, in the disaggregation, waveforms of currents (current consumption) consumed by the individual appliances are separated from, for example, a waveform of the total sum of currents that is the total sum data.

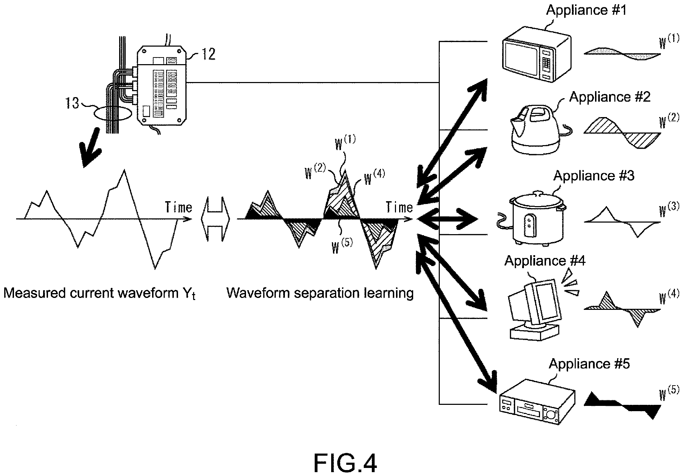

Fig. 4 is a diagram describing the outline of waveform separation learning performed in the disaggregation.

Waveform separation learning is performed in the disaggregation. In the waveform separation learning, a waveform of current consumption of each appliance is determined on the basis of the total sum data.

In the waveform separation learning, assuming that a current waveform $Y_t$, which is total sum data at each point of time t, is an addition value (total sum) of specific waveforms $W^{(m)}$ each indicating current consumption of each appliance #m, a specific waveform $W^{(m)}$ consumed by the individual appliance #m is determined from the current waveform $Y_t$.

In Fig. 4, the user's house includes five appliances #1 to #5. Among the five appliances #1 to #5, the appliances #1, #2, #4, and #5 are in an ON state (state in which power is consumed) and the appliance #3 is in an OFF state (state in which power is not consumed).

Therefore, in Fig. 4, the current waveform $Y_t$ that is the total sum data is an addition value (total sum) of the current consumption $W^{(1)}$, $W^{(2)}$, $W^{(4)}$, and $W^{(5)}$ of the appliances #1, #2, #4, and #5.

<Configuration Example of Disaggregation Apparatus 16>

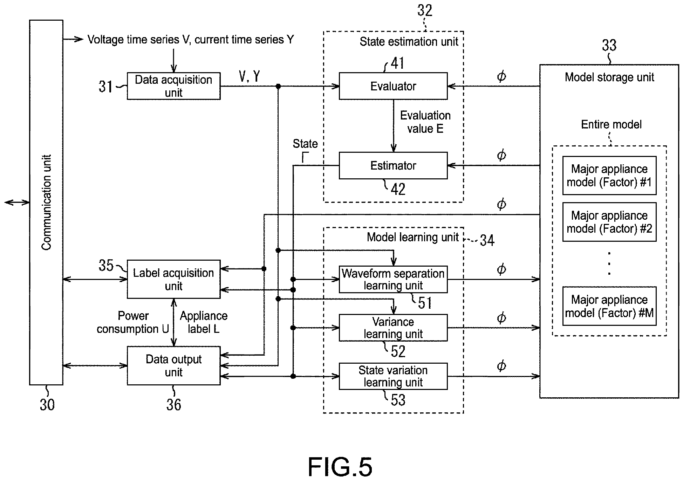

Fig. 5 is a block showing a configuration example of the disaggregation apparatus 16 of Fig. 1.

In Fig. 5, the disaggregation apparatus 16 includes a communication unit 30, a data acquisition unit 31, a state estimation unit 32, a model storage unit 33, a model learning unit 34, a label acquisition unit 35, and a data output unit 36.

The communication unit 30 communicates with the current sensor 13 or the agent 14 via the network 15.

Specifically, the communication unit 30 receives a time series of current waveforms Y (current time series) that is the total sum data sent from the current sensor 13 via the network 15. The communication unit 30 supplies it to the data acquisition unit 31.

Further, the communication unit 30 receives the data sent from the agent 14 via the network 15 and supplies it to the label acquisition unit 35 or the data output unit 36. In addition, the communication unit 30 sends the data supplied to the agent 14 from the label acquisition unit 35 or the data output unit 36 via the network 15.

Note that, in this embodiment, the communication may be any of wireless communication, wired communication, and wireless and wired communication.

The data acquisition unit 31 acquires a time series of current waveforms Y (current time series) that is the total sum data sent from the current sensor 13, by receiving it via the communication unit 30. The data acquisition unit 31 supplies it to the state estimation unit 32, the model learning unit 34, and the data output unit 36.

Further, the data acquisition unit 31 acquires a time series of waveforms (voltage waveforms) V (voltage time series) having a voltage corresponding to the current waveform Y that is the total sum data. The data acquisition unit 31 supplies it to the state estimation unit 32, the model learning unit 34, and the data output unit 36.

Note that, as in the current waveform Y, a voltage waveform V can be measured by the distribution board 12 and can be sent to the disaggregation apparatus 16 via the network 15. Further, a sine wave having a predetermined value, for example, a root mean square value of 100 V at a predetermined frequency of, for example, 50 Hz or 60 Hz, which approximates electricity provided from the power company, can be employed as the voltage waveform V.

The state estimation unit 32 performs state estimation. In the state estimation, a state of an entire model corresponding to the respective appliances of the user's house is estimated using the current waveform Y from the data acquisition unit 31 and (model parameters of) the entire model φ. Here, the entire model φ is a model of all the appliances of the user's house and stored in the model storage unit 33. Then, the state estimation unit 32 supplies (the state of the entire model that is) a state estimation result Γ of the state estimation to the model learning unit 34, the label acquisition unit 35, and the data output unit 36.

That is, in Fig. 5, the state estimation unit 32 includes an evaluator 41 and an estimator 42.

The evaluator 41 determines an evaluation value E and supplies it to the estimator 42. The evaluation value E is for evaluating a degree by which the current waveform Y supplied from the data acquisition unit 31 (to the state estimation unit 32) is observed in each of a combination of states of each of a plurality of appliance models #1 to #M that constitute the entire model φ stored in the model storage unit 33.

Using the evaluation value E supplied from the evaluator 41, the estimator 42 estimates the state Γ of each of the plurality of appliance models #1 to #M that constitute the entire model φ stored in the model storage unit 33. The estimator 42 supplies it to the model learning unit 34, the label acquisition unit 35, and the data output unit 36.

The model storage unit 33 stores (the model parameters of) the entire model φ that is the model of all the plurality of appliances.

The entire model φ is constituted of the appliance models #1 to #M that are models of a plurality of, i.e., an M-number of appliances (that represent current consumption). The appliance models #1 to #M and the entire model φ constituted of the appliance models #1 to #M are, for example, probability generation models or state transition models and includes a plurality of states.

The parameter φ of the entire model includes a current waveform parameter indicating current consumption for each of (operation states of the appliance corresponding to) states of the appliance model #m.

Other examples of the parameter φ of the entire model can include a state variation parameter indicating transition (variation) of (the operation states of the appliance corresponding to) the states of the appliance model #m, an initial state parameter indicating an initial state of (the operation states of the appliance corresponding to) the states of the appliance model #m, and a variance parameter relating to variance of an observed value of the current waveform Y observed (generated) in the entire model.

The model parameters φ of the entire model stored in the model storage unit 33 are referred by the evaluator 41 and the estimator 42 of the state estimation unit 32, the label acquisition unit 35, and the data output unit 36 if necessary. The model parameters φ of the entire model stored in the model storage unit 33 are updated by a waveform separation learning unit 51, a variance learning unit 52, and a state variation learning unit 53 of the model learning unit 34, which will be described later.

The model learning unit 34 performs model learning in which the model parameters φ of the entire model stored in the model storage unit 33 are updated, using the current waveform Y supplied from the data acquisition unit 31 and the state estimation result Γ of the state estimation (the states of the respective appliance models #m (that constitute the entire model)) supplied from (the estimator 42 of) the state estimation unit 32.

That is, in Fig. 5, the model learning unit 34 includes the waveform separation learning unit 51, the variance learning unit 52, and the state variation learning unit 53.

The waveform separation learning unit 51 performs waveform separation learning in which the current waveform parameter that is the model parameter φ is determined (updated), using the current waveform Y supplied from the data acquisition unit 31 (to the model learning unit 34) and the state estimation results Γ of the respective appliance models #m supplied from (the estimator 42 of) the state estimation unit 32. The waveform separation learning unit 51 updates the current waveform parameter stored in the model storage unit 33 using the current waveform parameter resulting from the waveform separation learning.

The variance learning unit 52 performs variance learning in which the variance parameter that is the model parameter φ is determined (updated), using the current waveform Y supplied from the data acquisition unit 31 (to the model learning unit 34) and the state estimation results Γ of the respective appliance models #m supplied from (the estimator 42 of) the state estimation unit 32. The variance learning unit 52 updates the variance parameter, which is stored in the model storage unit 33, using the variance parameter resulting from the variance learning.

The state variation learning unit 53 performs state variation learning in which the initial state parameter and the state variation parameter that are the model parameter φ are determined (updated), using the state estimation results Γ of the respective appliance models #m supplied from (the estimator 42 of) the state estimation unit 32. The state variation learning unit 53 updates the initial state parameter and the state variation parameter, which are stored in the model storage unit 33, using the initial state parameter and the state variation parameter, which results from the state variation learning.

The label acquisition unit 35 acquires an appliance label $L^{(m)}$ (for identifying the appliance) indicating the appliance corresponding to each appliance model #m, using the state estimation results Γ of the respective appliance models #m supplied from (the estimator 42 of) the state estimation unit 32, the entire model φ stored in the model storage unit 33, the power consumption $U^{(m)}$ of the appliances indicating the respective appliance models #m, which is obtained by the data output unit 36, data from the agent 14 supplied from the communication unit 30, and the like if necessary. The label acquisition unit 35 supplies it to the data output unit 36 if necessary.

The data output unit 36 determines the power consumption $U^{(m)}$ of each appliance of the user's house (that corresponds to each appliance model #m), which is indicated by each appliance model #m, using the voltage waveform V supplied from the data acquisition unit 31, the state estimation result $\Gamma$ of each appliance model #m supplied from (the estimator 42 of) the state estimation unit 32, and the entire model stored in the model storage unit 33. The data output unit 36 supplies it to the user who lives in the user's house or the like together with the appliance label $L^{(m)}$ supplied from the label acquisition unit 35.

Specifically, the data output unit 36 sends the power consumption $U^{(m)}$ and the appliance label $L^{(m)}$ of each of the appliances of the user's house to the agent 14 from the communication unit 30 via the network 15. By communicating with a display device including a display, for example, a TV in the user's house or a smartphone possessed by the user who lives in the user's house, the agent 14 is capable of sending the power consumption $U^{(m)}$ and the appliance label $L^{(m)}$ from the data output unit 36 to the display device.

Further, the data output unit 36 detects the operation state of each appliance of the user's house on the basis of the state estimation results $\Gamma$ of the respective appliance models #m. The data output unit 36 sends an operation state label indicating that operation state to the agent 14 from the communication unit 30 via the network 15. The agent 14 is capable of taking a predetermined action according to the operation state (label) of each appliance of the user's house from the data output unit 36.

In the thus configured disaggregation apparatus 16, an FHMM (Factorial Hidden Markov Model) can be, for example, employed as the entire model stored in the model storage unit 33.

<FHMM>

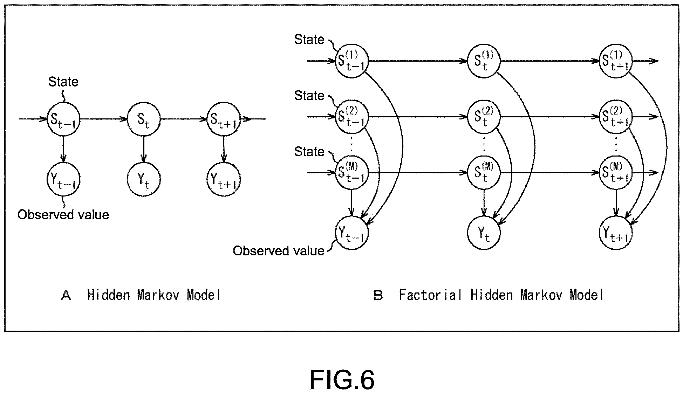

Fig. 6 is a diagram describing the FHMM.

Specifically, A of Fig. 6 shows a graphical model of a normal HMM and B of Fig. 6 shows a graphical model of the FHMM.

In the normal HMM, at a point of time t, a single observed value $Y_t$ is observed in a single state $S_t$ of being at the point of time t.

On the other hand, in the FHMM, at a point of time t, a single observed value $Y_t$ is observed in a combination of a plurality of states $S^{(1)}_t$, $S^{(2)}_t$, ..., $S^{(m)}_t$ of being at the point of time t.

The FHMM is a probability generation model proposed by Zoubin Ghahramani, et al. Details thereof are described in, for example, Zoubin Ghahramani, and Michael I. Jordan, Factorial Hidden Markov Models', Machine Learning Volume 29, Issue 2-3, Nov./Dec. 1997 (hereinafter, also referred to as Document A).

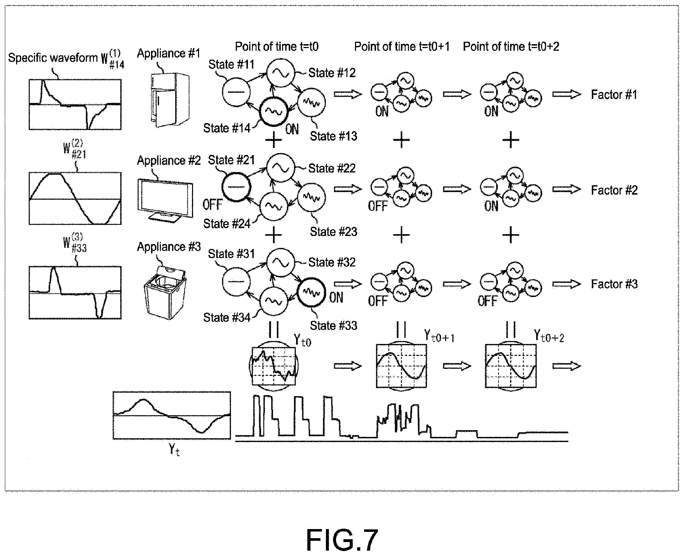

Fig. 7 is a diagram describing the outline of formulation of the disaggregation by the FHMM.

Here, the FHMM is configured to have a plurality of HMMs. Each of the HMMs of the FHMM is called factor. Hereinafter, a mth factor of the FHMM will be also referred to as a factor #m.

In the FHMM, a combination of a plurality of states $S^{(1)}_t$ to $S^{(M)}_t$ of being at the point of time t is a combination of the states of the factors #m (set of state of factor #1, state of factor #2,..., state of factor #M) of being at the point of time t.

Fig. 7 shows an FHMM in which the number M of factors is 3.

In the disaggregation, for example, one factor corresponds to one appliance (one factor is associated with one appliance). In Fig. 7, the factor #m corresponds to the appliance #m.

In the FHMM, the number of states of factors is arbitrary for each factor. However, in Fig. 7, the number of states of each of the three factors #1, #2, #3 is four.

In Fig. 7, at a point of time t = t0, the factor #1 is (has been) in a state #14 (indicated by solid-line circle) of four states #11, #12, #13, #14. The factor #2 is in a state #21 (indicated by solid-line circle) of four states #21, #22, #23, #24. Further, at the point of time t = t0, the factor #3 is in a state #33 (indicated by solid-line circle) of four states #31, #32, #33, #34.

In the disaggregation, the state of the factor #m corresponds to the operation state of the appliance #m corresponding to the factor #m, for example.

For example, in the factor #1 corresponding to the appliance #1, the state #11 corresponds to an OFF state of the appliance #1 and the state #14 corresponds to an ON state of the appliance #1 on a so-called normal mode. Further, for example, in the factor #1 corresponding to the appliance #1, the state #12 corresponds to an ON state of the appliance #1 on a so-called sleep mode. The state #13 corresponds to an ON state of the appliance #1 on a so-called energy-saving mode.

In the FHMM, a specific waveform $W^{(m)}_{\#mi}$ that is a waveform specific to each of the states of each factor is observed (generated) in a state #mi of a factor #m.

In Fig. 7, in the factor #1, in the state #14 of being at the point of time t = t0, a specific waveform $W^{(1)}_{\#14}$ is observed. In the factor #2, in the state #21 of being at the point of time t = t0, a specific waveform $W^{(2)}_{\#21}$ is observed. In addition, in the factor #3, in the state #33 of being at the point of time t = t0, a specific waveform $W^{(3)}_{\#33}$ is observed.

In the FHMM, a synthesized waveform obtained by synthesizing specific waveforms observed in states of being in the factors is generated as an observed value observed in the FHMM.

Here, for example, a total sum (addition) of specific waveforms can be employed for synthetization of specific waveforms. Otherwise, for example, weighting addition of specific waveforms or a logical sum of specific waveforms (when the values of the specific waveforms are 0 and 1) can be employed for synthetization of specific waveforms. However, in the disaggregation, the total sum of the specific waveforms is employed.

In the learning of the FHMM, in the FHMM, the model parameters of the FHMM are determined (updated) such that current waveforms ..., $Y_{t0}$, $Y_{t0+1}$, ... as total sum data of points of time t = ..., t0, t1, ... are observed.

When the FHMM as described above is employed as the entire model $\varphi$ stored in the model storage unit 33 (Fig. 5), the appliance models #m that constitute the entire model $\varphi$ correspond to the factors #m.

Note that a value larger than a maximum number of appliances, which are assumed to be present in the user's house, by a predetermined number that is a margin is employed as the number M of factors of the FHMM.

Further, an FHMM in which each factor has two states or three or more states can be employed as the FHMM that is the entire model $\varphi$.

When the number of states of a factor is two states, only two operation states, for example, OFF and ON states can be expressed as operation states of an appliance corresponding to the factor. Therefore, when the number of states of the factor is two states, it becomes difficult to accurately determine power consumption or the like with respect to an appliance (variable load appliance) having three or more operation states, such as an air conditioner whose power consumption (current) varies according to a mode, settings, or the like.

On the other hand, when an FHMM in which each factor has three or more states is employed as the FHMM that is the entire model $\varphi$, it becomes possible to accurately determine power consumption or the like with respect to a variable load appliance having three or more operation states.

When the FHMM is employed as the entire model $\varphi$, a joint probability distribution $P(\{S_t, Y_t\})$ of a sequence of the current waveforms $Y_t$ observed in the FHMM and a sequence of combinations $S_t$ of the states $S^{(m)}_t$ of the factors #m are calculated by Expression (1) by assuming Markov property.

[Expression 1]

$$P(\{S_t, Y_t\}) = P(S_1)P(Y_1|S_1)\prod_{t=2}^{T}P(S_t|S_{t-1})P(Y_t|S_t)$$

$$\cdots \ (1)$$

Here, the joint probability distribution $P(\{S_t, Y_t\})$ indicates a probability that the current waveform $Y_t$ is observed in the combination $S_t$ of the states $S^{(m)}_t$ of the factors #m (combination of states of each of an M-number of factors) at the point of time t.

$P(S_1)$ indicates an initial state probability of being in a combination $S_1$ of states $S^{(m)}_1$ of each factor #m at a first point of time t = 1.

$P(S_t|S_{t-1})$ indicates a transition probability of being in a combination $S_{t-1}$ of states at a point of time t-1 and transitioning to a combination $S_t$ of states at the point of time t.

$P(Y_t|S_t)$ indicates an observation probability that the current waveform $Y_t$ is observed in the combination $S_t$ of the states at the point of time t.

The combination $S_t$ of the states at the point of time t is a combination of states $S^{(1)}_t$, $S^{(2)}_t$, ..., $S^{(m)}_t$ of each of an M-number of factors #1 to #M at the point of time t and expressed by Expression $S_t = \{S^{(1)}_t, S^{(2)}_t, ..., S^{(m)}_t\}$.

Note that it is provided that the operation state of the appliance #m varies independently of other appliances #m' and it is assumed that the states $S^{(m)}_t$ of the factor #m transition independently of states $S^{(m')}_t$ of the other factors #m'.

Further, a number independent of the number $K^{(m')}$ of states of the HMM that are the other factors #m' can be employed as the number $K^{(m)}$ of states of the HMM that are the factors #m of the FHMM. It should be noted that, here, for the sake of description, it is assumed that the number $K^{(1)}$ to $K^{(M)}$ of states of the factors #1 to #M is an identical number K as expressed by Expression $K^{(1)} = K^{(2)} = ... = K^{(M)} = K$.

In the FHMM, the initial state probability $P(S_1)$, the transition probability $P(S_t|S_{t-1})$, and the observation probability $P(Y_t|S_t)$, which are necessary for calculating the joint probability distribution $P(\{S_t, Y_t\})$ of Expression (1), can be calculated as follows.

That is, the initial state probability $P(S_1)$ can be calculated according to Expression (2).

[Expression 2]

$$P(S_1) = \prod_{m=1}^{M} P\left(S_1^{(m)}\right)$$

$$\ldots \ (2)$$

Here, $P(S^{(m)}_1)$ indicates an initial state probability that the state $S^{(m)}_1$ of the factor #m is a state (initial state) at the first point of time t = 1.

The initial state probability $P(S^{(m)}_1)$ is, for example, a column vector with K rows (matrix with K rows and 1 column) with an initial state probability of a kth (k = 1, 2, ..., K) state of the factor #m being a kth component.

The transition probability $P(S_t|S_{t-1})$ can be calculated according to Expression (3).

[Expression 3]

$$P(S_t|S_{t-1}) = \prod_{m=1}^{M} P\left(S_t^{(m)}|S_{t-1}^{(m)}\right)$$

$$\ldots \ (3)$$

Here, $P(S^{(m)}_t|S^{(m)}_{t-1})$ indicates a transition probability of being in a state $S^{(m)}_{t-1}$ at the point of time t-1 and transitioning to a state $S^{(m)}_t$ at the point of time t in the factor #m.

The transition probability $P(S^{(m)}_t|S^{(m)}_{t-1})$ is, for example, a matrix (square matrix) with K rows and K columns with a transition probability of transitioning from a kth state #k of the factor #m to a k'th (k' = 1, 2, ..., K) state #k' being a component in kth row and k'th column.

The observation probability $P(Y_t|S_t)$ can be calculated according to Expression (4).

[Expression 4]

$$P(Y_t|S_t) = |C|^{-1/2}(2\pi)^{-D/2}\exp\left\{-\frac{1}{2}(Y_t-\mu_t)'C^{-1}(Y_t-\mu_t)\right\}$$

$$\ldots \ (4)$$

Here, the dash (') indicates transposition and the superscript -1 indicates a multiplicative inverse (inverse matrix). Further, |C| indicates an absolute value of C (determinant) (determinant calculation).

Further, D indicates a dimension of the observed value $Y_t$.

For example, with a timing having zero crossing when a voltage changes from a negative value to a positive value being a timing at which a phase of a current is 0, the current sensor 13 samples a current for one cycle (1/50 or 1/60 seconds in Japan) at predetermined sampling intervals. The current sensor 13 outputs a column vector with the sampled value being a component, as a current waveform $Y_t$ for one point of time.

Assuming that the number of times of sampling by which the current sensor 13 samples a current for one cycle is D, the current waveform $Y_t$ is a column vector with D rows.

In accordance with the observation probability $P(Y_t|S_t)$ of Expression (4), the observed value $Y_t$ is based on a normal distribution in which a mean value (mean vector) is $\mu_t$ and variance (variance-covariance matrix) is C.

The mean value $\mu_t$ is a column vector with D rows as in the current waveform $Y_t$ and the variance C is a matrix with D rows and D columns (matrix with diagonal components being variance).

The mean value $\mu_t$ is expressed by Expression (5) using the specific waveform $W^{(m)}$ described above with reference to Fig. 7.

[Expression 5]

$$\mu_t = \sum_{m=1}^{M} W^{(m)} S_t^{*(m)}$$

$$\ldots \quad (5)$$

Here, it is assumed that the specific waveform of the state #k of the factor #m is denoted by $W^{(m)}{}_k$. Then, the specific waveform $W^{(m)}{}_k$ of the state #k of the factor #m is, for example, a column vector with D rows as in the current waveform $Y_t$.

Further, the specific waveform $W^{(m)}$ is a collection of specific waveforms $W^{(m)}{}_1$, $W^{(m)}{}_2$, ..., $W^{(m)}{}_K$ of states #1, #2, ..., #K of the factor #m. The specific waveform $W^{(m)}$ is a matrix with D rows and K columns with a column vector that is the specific waveform $W^{(m)}{}_k$ of the state #k of the factor #m being a component in a kth column.

In addition, $S^{*(m)}{}_t$ indicates the state of the factor #m of being at the point of time t. Hereinafter, $S^{*(m)}{}_t$ will also be referred to as a current state of the factor #m at the point of time t. The current state $S^{*(m)}{}_t$ of the factor #m at the point of time t is a column vector with K rows in which a component in only one row of the K rows are 1 and components in other rows are 0 as shown in Expression (6), for example.

[Expression 6]

$$S_t^{*(m)} = \begin{pmatrix} 0 \\ \vdots \\ 1 \\ \vdots \\ 0 \end{pmatrix}$$

$$\ldots \quad (6)$$

When the state of the factor #m of being at the point of time t is the state #k, only the kth component is set to 1 and other components are set to 0 in a column vector $S^{*(m)}{}_t$ with K rows that is the current state $S^{*(m)}{}_t$ of the factor #m at the point of time t.

In accordance with Expression (5), a total sum of the specific waveforms $W^{(m)}{}_k$ of the states #k of each factor #m at the point of time t is determined as the mean value $\mu_t$ of the current waveforms $Y_t$ at the point of time t.

The model parameters $\varphi$ of the FHMM are the initial state probability $P(S^{(m)}{}_1)$ of Expression (2), the transition probability $P(S^{(m)}{}_t|S^{(m)}{}_{t-1})$ of Expression (3), the variance C of Expression (4), and the specific waveform $W^{(m)}$ (= $W^{(m)}{}_1$, $W^{(m)}{}_2$, ..., $W^{(m)}{}_K$) of Expression (5). In the model learning unit 34 of Fig. 5, the model parameters $\varphi$ of the FHMM are determined.

Specifically, the waveform separation learning unit 51 performs waveform separation learning, to thereby determine the specific waveform $W^{(m)}$ as the current waveform parameter. The variance learning unit 52 performs variance learning, to thereby determine the variance C as the variance parameter. The state variation learning unit 53 performs state variation learning, to thereby determine the initial state probability $P(S^{(m)}{}_1)$ and the transition probability $P(S^{(m)}{}_t|S^{(m)}{}_{t-1})$ as the initial state parameter and the state variation parameter, respectively.

Here, for example, even if the operation states of the individual appliances are two states of ON and OFF, when (a combination of) operation states of 20 appliances is expressed by the normal HMM, the number of states of the HMM is $2^{20} = 1,048,576$ and the number of transition probabilities is 1,099,511,627,776, which is the square thereof.

On the other hand, in accordance with the FHMM, an M-number of appliances having only two states of ON and OFF as the operation states can be expressed by an M-number of factors each having two states. Therefore, in each factor, the number of states is two and the number of transition probabilities is four, which is the square thereof. Thus, when the operation states of M = 20 appliances (factors) are expressed by the FHMM, the number (total number) of states of the FHMM only has to be a small number, i.e., 40 = 2 * 20 and the number of transition probabilities also only has to be a small number, i.e., 80 = 4 * 20.

The learning of the FHMM, i.e., updating of the initial state probability $P(S^{(m)}{}_1)$, the transition probability $P(S^{(m)}{}_t|S^{(m)}{}_{t-1})$, the variance C, and the specific waveform $W^{(m)}$ that are the model parameters $\varphi$ of the FHMM can be performed according to an EM (Expectation-Maximization) algorithm as described in Document A, for example.

In the learning of the FHMM using the EM algorithm, the processing of the E step and the processing of the M step are alternately repeated in order to maximize an expected value $Q(\varphi^{new}|\varphi)$ of a conditional complete-data log-likelihood of Expression (7).
[Expression 7]

$$Q(\phi^{new}|\phi) = E\left\{ \log P\left( \{S_t, Y_t\} | \phi^{new} \right) | \phi, \{S_t, Y_t\} \right\}$$

$$\ldots \quad (7)$$

Here, the expected value $Q(\varphi^{new}|\varphi)$ of the conditional complete-data log-likelihood means an expected value of a log likelihood $\log(P(\{S_t, Y_t\}|\varphi^{new}))$ that the complete data $\{S_t, Y_t\}$ is observed under a new model parameter $\varphi^{new}$ when the complete data $\{S_t, Y_t\}$ is observed under the model parameter $\varphi$.

In the processing of the E step of the EM algorithm, (a value equivalent to) the expected value $Q(\varphi^{new}|\varphi)$ of the conditional complete-data log-likelihood of Expression (7) is determined. In the processing of the M step of the EM algorithm, a new model parameter $\varphi^{new}$ that increases the expected value $Q(\varphi^{new}|\varphi)$ determined in the processing of the E step is determined, and the model parameter $\varphi$ is updated to the new model parameter $\varphi^{new}$ (that increases the expected value $Q(\varphi^{new}|\varphi)$).

<Model Learning of FHMM as Disaggregation>

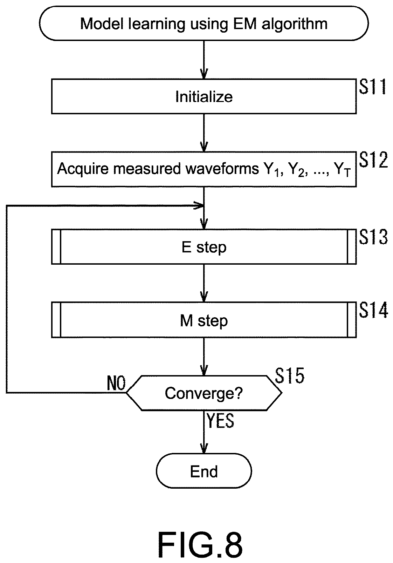

Fig. 8 is a flowchart describing an example of processing (learning processing) of model learning of the FHMM based on the EM algorithm that is the disaggregation performed by the disaggregation apparatus 16 (Fig. 5).

In Step S11, the model learning unit 34 initializes the initial state probability $P(S^{(m)}_1)$, the transition probability $P(S^{(m)}_t|S^{(m)}_{t-1})$, the variance C, and the specific waveform $W^{(m)}$ that are the model parameters $\varphi$ of the FHMM, which are stored in the model storage unit 33. Then, the processing proceeds to Step S12.

Here, a kth component of a column vector with K rows that is the initial state probability $P(S^{(m)}_1)$, i.e., a kth initial state probability $\pi^{(m)}_k$ of the factor #m is initialized to 1/K, for example.

In a component (i,j = 1, 2, ..., K) in ith row and jth column of a matrix with K rows and K columns that is the transition probability $P(S^{(m)}_t|S^{(m)}_{t-1})$, i.e., a factor #m, a transition probability $P^{(m)}_{i,j}$ of transitioning from an ith state #i to a jth state #j is initialized so as to satisfy Expression $P^{(m)}_{i,1} + P^{(m)}_{i,2} + ... + P^{(m)}_{i,K} = 1$, using a random number, for example.

A matrix with D rows and D columns that is the variance C is initialized to a diagonal matrix in Dth row and Dth column with a diagonal component being set using a random number and other components being 0, for example.

A column vector in a kth column of a matrix with D rows and K columns that is the specific waveform $W^{(m)}$, i.e., each component of a column vector with D rows that is the specific waveform $W^{(m)}_k$ of the state #k of the factor #m is initialized using, for example, a random number.

In Step S12, the data acquisition unit 31 acquires a current waveform for a predetermined time T measured by the current sensor 13 and supplies current waveforms $Y_1, Y_2, ..., Y_T$ (hereinafter, also referred to as measured waveforms) at points of time t = 1, 2..., T to the state estimation unit 32 and the model learning unit 34. Then, the processing proceeds to Step S13.

Here, the data acquisition unit 31 also acquires voltage waveforms as well as current waveforms at points of time t = 1, 2..., T. The data acquisition unit 31 supplies the voltage waveforms at the points of time t = 1, 2..., T to the data output unit 36.

In the data output unit 36, the voltage waveforms from the data acquisition unit 31 are used for calculating power consumption.

In Step S13, the state estimation unit 32 performs the processing of the E step using measured waveforms $Y_1$ to $Y_T$ from the data acquisition unit 31. Then, the processing proceeds to Step S14.

Specifically, in Step S13, the state estimation unit 32 performs state estimation in which the state probability or the like in each of the states of each factor #m of the FHMM stored in the model storage unit 33, using the measured waveforms $Y_1$ to $Y_T$ from the data acquisition unit 31. The state estimation unit 32 supplies a state estimation result of the state estimation to the model learning unit 34 and the data output unit 36.

Here, as described above with reference to Fig. 7, in the disaggregation, the state of the factor #m corresponds to the operation state of the appliance #m to which the factor #m corresponds. A state probability of being in a state #k of the factor #m of the FHMM indicates a degree of correspondence between the operation state of the appliance #m and the state #k. Therefore, it can be said that the state estimation that determines such a state probability determines (estimates) the operation state of the appliance.

In Step S14, the model learning unit 34 performs the processing of the M step using the measured waveforms $Y_1$ to $Y_T$ from the data acquisition unit 31 and the state estimation result from the state estimation unit 32. Then, the processing proceeds to Step S15.

Specifically, in Step S14, the model learning unit 34 performs learning of the FHMM stored in the model storage unit 33 using the measured waveforms $Y_1$ to $Y_T$ from the data acquisition unit 31 and the state estimation result from the state estimation unit 32, to thereby update the initial state probability $\pi^{(m)}_k$, the transition probability $P^{(m)}_{i,j}$, the variance C, and the specific waveform $W^{(m)}$ that are the model parameters $\varphi$ of the FHMM stored in the model storage unit 33.

In Step S15, the model learning unit 34 determines whether or not a convergence condition of the model parameter $\varphi$ is satisfied.

Here, for example, the fact that the processing of the E step and the M step is repeated by a predetermined number of times set in advance or that an amount of change before and after updating the model parameter $\varphi$ of the likelihood observed by the measured waveforms $Y_1$ to $Y_T$ in the FHMM is within a threshold set in advance can be employed as the convergence condition of the model parameter $\varphi$.

When it is determined in Step S15 that the convergence condition of the model parameter $\varphi$ is not satisfied, the processing returns to Step S13 and similar processing is then repeated.

Further, when it is determined in Step S15 that the convergence condition of the model parameter $\varphi$ is satisfied, the learning processing is terminated.

Note that the processing in Steps S12 to S15 is repeatedly performed regularly or irregularly.

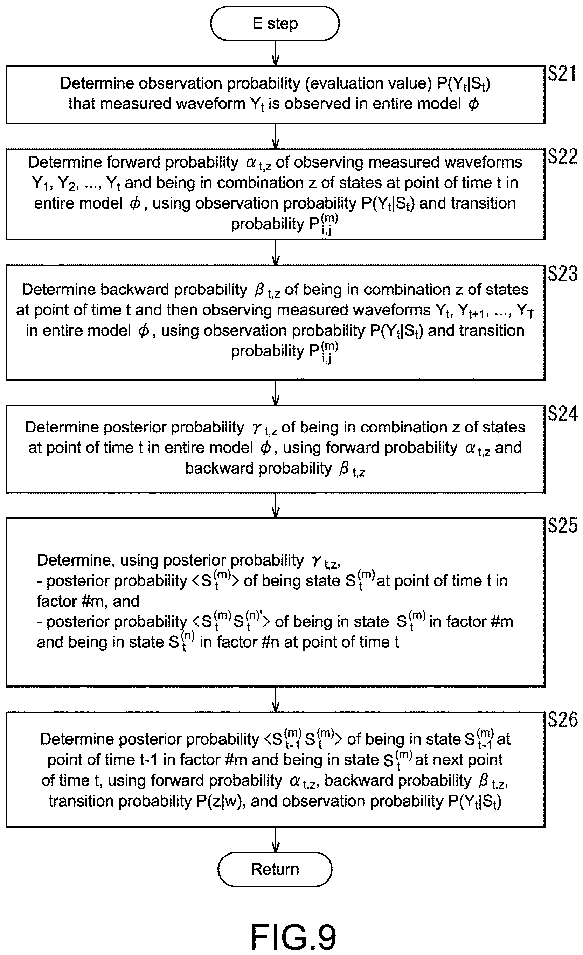

Fig. 9 is a flowchart describing processing of the E step, which is performed by the disaggregation apparatus 16 of Fig. 5 in Step S13 of Fig. 8.

In Step S21, using the variance C and the specific waveform $W^{(m)}$ of the FHMM that is the entire model $\varphi$ stored in the model storage unit 33 and measured waveforms $Y_t = \{Y_1, Y_2, ..., Y_T\}$ from the data acquisition unit 31, the evaluator 41 determines an observation probability $P(Y_t|S_t)$ of Expression (4) as the evaluation value E with respect to each combination $S_t$ of states at each point of time $t = \{1, 2, ..., T\}$. The evaluator 41 supplies it to the estimator 42. Then, the processing proceeds to Step S22.

In Step S22, using the observation probability $P(Y_t|S_t)$ from the evaluator 41 and the transition probability $P^{(m)}_{i,j}$ (and the initial state probability $\pi^{(m)}$) of the FHMM that is the entire model $\varphi$ stored in the model storage unit 33, the estimator 42 observes the measured waveforms $Y_1, Y_2, ..., Y_t$ and determines a forward probability $\alpha_{t,z}$ of being in a combination z of states at the point of time t (combination of state of factor #1, state of factor #2, ..., state of factor #M at point of time t). Then, the processing proceeds to Step S23.

Here, how to determine the forward probability of the HMM is described in, for example, page 336 of "Pattern Recognition and Machine Learning - Statistical Prediction based on Bayesian Theory" by C. M. Bishop, Springer Japan, 2008 (hereinafter, also referred to as Document B).

The forward probability $\alpha_{t,z}$ can be determined according to a recurrence relation $\alpha_{t,z} = \Sigma\alpha_{t-1,w}P(z|w)P(Y_t|z)$ using the forward probability $\alpha_{t-1,w}$ at a previous point of time, for example.

In the recurrence relation $\alpha_{t,z} = \Sigma\alpha_{t-1,w}P(z|w)P(Y_t|z)$, $\Sigma$ indicates summation taken by setting w to all of the combinations of the states of the FHMM.

Further, in the recurrence relation $\alpha_{t,z} = \Sigma\alpha_{t-1,w}P(z|w)P(Y_t|z)$, w indicates a combination of states of being at the point of time t-1 that is the previous point of time. P(z|w) indicates a transition probability of being in the combination w of the states at the point of time t-1 and transitioning to the combination z of the states at the point of time t. $P(Y_t|z)$ indicates an observation probability of observing a measured waveform $Y_t$ in the combination z of the states at the point of time t.

Note that a product of the initial state probabilities $\pi^{(m)}_k$ of the states #k of each factor #m that constitute the combination z of the states is employed as an initial value of the forward probability $\alpha_{t,z}$, i.e., a forward probability $\alpha_{1,z}$ at the point of time t = 1.

In Step S23, using the observation probability $P(Y_t|S_t)$ from the evaluator 41 and the transition probability $P^{(m)}_{i,j}$ of the FHMM that is the entire model $\varphi$ stored in the model storage unit 33, the estimator 42 determines a backward probability $\beta_{t,z}$ of being in the combination z of the states at the point of time t and then observing measured waveforms $Y_t, Y_{t+1}, ..., Y_T$. Then, the processing proceeds to Step S24.

Here, how to determine the backward probability of the HMM is described in page 336 of Document B above, for example.

The backward probability $\beta_{t,z}$ can be determined according to a recurrence relation $\beta_{t,z} = \Sigma P(Y_t|z)P(w|z)\beta_{t+1,w}$ using a backward probability $\beta_{t+1,w}$ at a next point of time, for example.

In the recurrence relation $\beta_{t,z} = \Sigma P(Y_t|z)P(w|z)\beta_{t+1,w}$, $\Sigma$ indicates summation taken by setting w to all of the combinations of the states of the FHMM.

Further, in the recurrence relation $\beta_{t,z} = \Sigma P(Y_t|z)P(w|z)\beta_{t+1,w}$, w indicates the combination of the states of being at a point of time t+1 that is the next point of time. P(w|z) indicates a transition probability of being in the combination z of the states at the point of time t and transitioning to the combination w of the states at the point of time t+1. $P(Y_t|z)$ indicates an observation probability of observing a measured waveform $Y_t$ in the combination z of the states at the point of time t.

Note that 1 is employed as an initial value of the backward probability $\beta_{t,z}$, i.e., the backward probability $\beta_{t,z}$ at the point of time t = T.

In Step S24, using the forward probability $\alpha_{t,z}$ and the backward probability $\beta_{t,z}$, the estimator 42 determines a posterior probability $\gamma_{t,z}$ of being in the combination z of the states at the point of time t in the FHMM that is the entire model $\varphi$ according to Expression (8). Then, the processing proceeds to Step S25.
[Expression 8]

$$\gamma_{t,z} = \frac{\alpha_{t,z}\beta_{t,z}}{\sum_{w \in S_t} \alpha_{t,w}\beta_{t,w}}$$

$$\ldots \quad (8)$$

Here, $\Sigma$ of a denominator on a right side of Expression (8) indicates summation taken by setting w to all of the combinations $S_t$ of the states that can be taken at the point of time t.
In accordance with Expression (8), the posterior probability $\gamma_{t,z}$ is determined by normalizing a product $\alpha_{t,z}\beta_{t,z}$ of the forward probability $\alpha_{t,z}$ and the backward probability $\beta_{t,z}$ using a total sum $\Sigma\alpha_{t,w}\beta_{t,w}$ of such products $\alpha_{t,w}\beta_{t,w}$ with respect to a combination $w \in S_t$ of states that can be taken by the FHMM.
In Step S25, using the posterior probability $\gamma_{t,z}$, the estimator 42 determines a posterior probability $<S^{(m)}_t>$ of being in the state $S^{(m)}_t$ at the point of time t in the factor #m and a posterior probability $<S^{(m)}_t S^{(n)}_t{}'>$ of being in the state $S^{(m)}_t$ in the factor #m at the point of time t and a posterior probability $<S^{(m)}_t S^{(n)}_t{}'>$ of being in the state $S^{(n)}_t$ in another factor #n. Then, the processing proceeds to Step S26.
Here, the posterior probability $<S^{(m)}_t>$ is determined according to Expression (9).
[Expression 9]

$$\left\langle S^{(m)}_t \right\rangle = \sum_{z \in S^{(n)}_t (n \neq m)} \gamma_{t,z}$$

$$\ldots \quad (9)$$

In accordance with Expression (9), in the factor #m, the posterior probability $<S^{(m)}_t>$ of being in the state $S^{(m)}_t$ at the point of time t is determined by marginalizing the posterior probability $\gamma_{t,z}$ of being in the combination z of the states at the point of time t with respect to the combination z of the states not including the states of the factor #m.
Note that the posterior probability $<S^{(m)}_t>$ is a column vector with K rows with a state probability (posterior probability) of being in a kth state of a K-number of states of the factor #m at the point of time t being a kth component, for example.
The posterior probability $<S^{(m)}_t S^{(n)}_t{}'>$ is determined according to Expression (10).
[Expression 10]

$$\left\langle S^{(m)}_t S^{(n)}_t{}' \right\rangle = \sum_{z \in S^{(r)}_t (r \neq m \wedge r \neq n)} \gamma_{t,z}$$

$$\ldots \quad (10)$$

In accordance with Expression (10), the posterior probability $<S^{(m)}_t S^{(n)}_t{}'>$ of being in the state $S^{(m)}_t$ at the point of time t in the factor #m and being in the state $S^{(n)}_t$ in the other factor #n is determined by marginalizing the posterior probability $\gamma_{t,z}$ of being in the combination z of the states at the point of time t with respect to the combination z of the states not including both of the states of the factor #m and the states of the factor #n.
Note that the posterior probability $<S^{(m)}_t S^{(n)}_t{}'>$ is a matrix with K rows and K columns with a state probability (posterior probability) of being in the state #k of the factor #m and in the state #k' of the other factor #n at the point of time t being a component in kth row and k'th column, for example.
In Step S26, using the forward probability $\alpha_{t,z}$, the backward probability $\beta_{t,z}$, the transition probability P(z|w), and the observation probability P(Y_t|S_t) from the evaluator 41, the estimator 42 determines a posterior probability

$<S^{(m)}_{t-1}S^{(m)}_t{}'>$ of being in the state $S^{(m)}_{t-1}$ at the point of time t-1 and being in the state $S^{(m)}_t$ at a next point of time t in the factor #m.

Then, the estimator 42 supplies the posterior probabilities $<S^{(m)}_t>$, $<S^{(m)}_tS^{(n)}_t{}'>$, and $<S^{(m)}_{t-1}S^{(m)}_t{}'>$ as state estimation results to the model learning unit 34, the label acquisition unit 35, and the data output unit 36. Then, the processing returns from the processing of the E step.

Here, the posterior probability $<S^{(m)}_{t-1}S^{(m)}_t{}'>$ is determined according to Expression (11).

[Expression 11]

$$\left\langle S^{(m)}_{t-1} S^{(m)}_t{}' \right\rangle = \frac{\displaystyle\sum_{w\in S^{(n)}_{t-1},\, z\in S^{(r)}_t (n\neq m \wedge r\neq m)} \alpha_{t-1,w} P(z|w) P(Y_t|z) \beta_{t,z}}{\displaystyle\sum_{w\in S_{t-1},\, z\in S_t} \alpha_{t-1,w} P(z|w) P(Y_t|z) \beta_{t,z}}$$

$$\dots \quad (11)$$

For calculating the posterior probability $<S^{(m)}_{t-1}S^{(m)}_t{}'>$ in Expression (11), the transition probability $P(z|w)$ of transitioning from the combination w of the states to the combination z of the states is, according to Expression (3), determined as a product $P^{(1)}_{i(1),j(1)} * P^{(2)}_{i(2),j(2)} * \dots * P^{(M)}_{i(M),j(M)}$ of a transition probability $P^{(1)}_{i(1),j(1)}$ from a state #i(1) of the factor #1 that constitutes the combination w of the states to a state #j(1) of the factor #1 that constitutes the combination z of the states, a transition probability $P^{(2)}_{i(2),j(2)}$, ..., from a state #i(2) of the factor #2 that constitutes the combination w of the states to a state #j(2) of the factor #2 that constitutes the combination z of the states, and a transition probability $P^{(M)}_{i(M),j(M)}$ from a state #i(M) of the factor #m that constitutes the combination w of the states to a state #j(M) of the factor #m that constitutes the combination z of the states.

Note that the posterior probability $<S^{(m)}_{t-1}S^{(m)}_t{}'>$ is a matrix with K rows and K columns with a state probability (posterior probability) of being in the state #i at the point of time t-1 and a state probability (posterior probability) of being in a state j at a next point of time t in the factor #m being a component in ith row and jth column, for example.

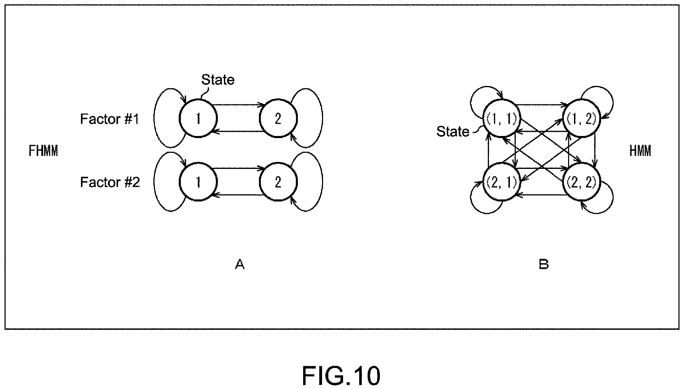

Fig. 10 is a diagram describing a relationship between the forward probability $\alpha_{t,z}$ and backward probability $\beta_{t,z}$ of the FHMM and the forward probability $\alpha_{t,i}$ and backward probability $\beta_{t,j}$ of the (normal) HMM.

For the FHMM, the HMM equivalent to that FHMM can be configured.

An HMM equivalent to a certain FHMM has states equivalent to the combination z of the states of the factors of the FHMM.

Then, the forward probability $\alpha_{t,z}$ and the backward probability $\beta_{t,z}$ of the FHMM are equal to the forward probability $\alpha_{t,i}$ and the backward probability $\beta_{t,j}$ of the HMM equivalent to that FHMM.

A of Fig. 10 shows an FHMM formed of factors #1 and #2 of two states #1 and #2.

In the FHMM of A of Fig. 10, with a combination z = [k, k'] of a state #k of the factor #1 and a state #k' of the factor #2, there are four patterns including a combination [1, 1] of a state #1 of the factor #1 and a state #1 of the factor #2, a combination [1, 2] of the state #1 of the factor #1 and a state #2 of the factor #2, a combination [2, 1] of a state #2 of the factor #1 and the state #1 of the factor #2, and a combination [2, 2] of the state #2 of the factor #1 and the state #2 of the factor #2.

B of Fig. 10 shows an HMM equivalent to the FHMM of A of Fig. 10.

The HMM of B of Fig. 10 has four states #(1, 1), #(1, 2), #(2, 1), and #(2, 2) respectively equivalent to four combinations [1, 1], [1, 2], [2, 1], and [2, 2] of the states of the FHMM of A of Fig. 10.

Then, a forward probability $\alpha_{t,z} = \{\alpha_{t,[1,1]}, \alpha_{t,[1,2]}, \alpha_{t,[2,1]}, \alpha_{t,[2,2]}\}$ of the FHMM of A of Fig. 10 is the same as a forward probability $\alpha_{t,i} = \{\alpha_{t,(1,1)}, \alpha_{t,(1,2)}, \alpha_{t,(2,1)}, \alpha_{t,(2,2)}\}$ of the HMM of B of Fig. 10.

Similarly, a backward probability $\beta_{t,z} = \{\beta_{t,[1,1]}, \beta_{t,[1,2]}, \beta_{t,[2,1]}, \beta_{t,[2,2]}\}$ of the FHMM of A of Fig. 10 is the same as a forward probability $\beta_{t,i} = \{\beta_{t,(1,1)}, \beta_{t,(1,2)}, \beta_{t,(2,1)}, \beta_{t,(2,2)}\}$ of the HMM of B of Fig. 10.

For example, a denominator on a right side of Expression (8) above, i.e., a total sum $\Sigma\alpha_{t,w}\beta_{t,w}$ of products $\alpha_{t,w}\beta_{t,w}$ with respect to a combination $w\in S_t$ of states that can be taken by the FHMM, is expressed by Expression $\Sigma\alpha_{t,w}\beta_{t,w} = \alpha_{t,[1,1]}\beta_{t,[1,1]} + \alpha_{t,[1,2]}\beta_{t,[1,2]} + \alpha_{t,[2,1]}\beta_{t,[2,1]} + \alpha_{t,[2,2]}\beta_{t,[2,2]}$ with respect to the FHMM of A of Fig. 10.

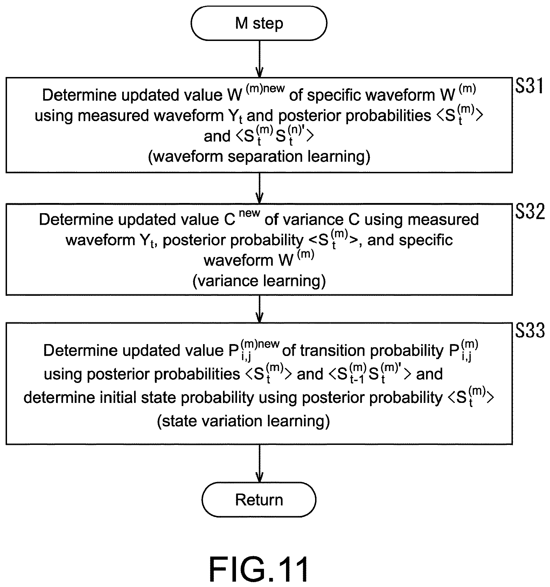

Fig. 11 is a flowchart describing processing of the M step, which is performed by the disaggregation apparatus 16 of Fig. 5 in Step S14 of Fig. 8.

In Step S31, the waveform separation learning unit 51 performs waveform separation learning using the measured waveform $Y_t$ from the data acquisition unit 31 and the posterior probabilities $<S^{(m)}_t>$ and $<S^{(m)}_tS^{(n)}_t{}'>$ from the estimator 42, to thereby determine an updated value $W^{(m)new}$ of the specific waveform $W^{(m)}$. The waveform separation learning unit 51 updates the specific waveforms W(m) stored in the model storage unit 33, using the updated value $W^{(m)new}$. Then, the processing proceeds to Step S32.

Specifically, for the waveform separation learning, the waveform separation learning unit 51 calculates Expression (12) to thereby determine the updated value $W^{(m)new}$ of the specific waveform $W^{(m)}$.
[Expression 12]

$$W^{new} = \left( \sum_{t=1}^{T} Y_t \langle S_t' \rangle \right) \left( \sum_{t=1}^{T} \langle S_t S_t' \rangle \right)^*$$

$$\ldots \quad (12)$$

Here, $W^{new}$ is a matrix with D rows and K*M columns in which the updated values $W^{(m)new}$ of the specific waveforms $W^{(m)}$ of the factors #m, each of which is the matrix with D rows and K columns, are arranged from the left to the right in the order of (indexes of) the factors #m. A column vector with (m-1)K+k columns of (the updated values of) the specific waveforms $W^{new}$, each of which is the matrix with D rows and K*M columns, is (an updated value of) the specific waveform $W^{(m)}_k$ of the state #k of the factor #m.

$\langle S_t' \rangle$ is a row vector with K*M columns obtained by transposing the column vector of K*M rows in which the posterior probabilities $\langle S^{(m)}_t \rangle$, each of which is a column vector with K rows, are arranged from the top to the bottom in the order of the factors #m. A component in a (m-1)K+kth column of the posterior probability $\langle S_t' \rangle$ that is the row vector with K*M columns is a state probability of being in the state #k of the factor #m at the point of time t.

$\langle S_t S_t' \rangle$ is a matrix with K*M rows and K*M columns in which the posterior probabilities $\langle S^{(m)}_t S^{(n)}_t' \rangle$, each of which is the matrix with K rows and K columns, are arranged from the top to the bottom in the order of the factors #m and arranged from the left to the right in the order of the factors #n. A component in (m-1)K+kth row and (n-1)K+k'th column of the posterior probability $\langle S_t S_t' \rangle$ that is a matrix with K*M rows and K*M columns is a state probability of being in the state #k of the factor #m and the state #k' of the other factor #n at the point of time t.

The superscript asterisk (*) indicates an inverse matrix or a pseudo-inverse matrix.

In accordance with the waveform separation learning in which Expression (12) is calculated, the measured waveform $Y_t$ is separated into the specific waveforms $W^{(m)}$ such that an error between the measured waveform $Y_t$ and a mean value $\mu_t = \Sigma W^{(m)} S^{*(m)}_t$ of Expression (5) is as small as possible.

In Step S32, the variance learning unit 52 performs variance learning using the measured waveform $Y_t$ from the data acquisition unit 31, the posterior probability $\langle S^{(m)}_t \rangle$ from the estimator 42, and the specific waveforms W(m) stored in the model storage unit 33, to thereby determine the updated value $C^{new}$ of the variance C. The variance learning unit 52 updates the variance C stored in the model storage unit 33. Then, the processing proceeds to Step S33.

Specifically, for the variance learning, the variance learning unit 52 calculates Expression (13), to thereby determine the updated value $C^{new}$ of the variance C.
[Expression 13]

$$C^{new} = \frac{1}{T} \sum_{t=1}^{T} Y_t Y_t' - \frac{1}{T} \sum_{t=1}^{T} \sum_{m=1}^{M} W^{(m)} \langle S^{(m)}_t \rangle Y_t'$$

$$\ldots \quad (13)$$

In Step S33, the state variation learning unit 53 performs state variation learning using the posterior probabilities $\langle S^{(m)}_t \rangle$ and $\langle S^{(m)}_{t-1} S^{(m)}_t' \rangle$ from the estimator 42, to thereby determine an updated value $P^{(m)new}_{i,j}$ of the transition probability $P^{(m)}_{i,j}$ and an updated value $\pi^{(m)new}$ of the initial state probability $\pi^{(m)}$. The state variation learning unit 53 updates the transition probability $P^{(m)}_{i,j}$ and the initial state probability $\pi^{(m)}$, which are stored in the model storage unit 33, using the updated values $P^{(m)new}_{i,j}$, and $\pi^{(m)new}$. Then, the processing returns from the processing of the M step.

Specifically, for the state variation learning, the state variation learning unit 53 calculates Expression (14) and Expression (15), to thereby determine the updated value $P^{(m)new}_{i,j}$ of the transition probability $P^{(m)}_{i,j}$ and the updated value $\pi^{(m)new}$ of the initial state probability $\pi^{(m)}$.
[Expression 14]

$$P_{i,j}^{(m)\,new} = \frac{\sum_{t=2}^{T} \left\langle S_{t-1,i}^{(m)} S_{t,j}^{(m)} \right\rangle}{\sum_{t=2}^{T} \left\langle S_{t-1,i}^{(m)} \right\rangle}$$

$$\dots \ (14)$$

[Expression 15]

$$\pi^{(m)\,new} = \left\langle S_{1}^{(m)} \right\rangle$$

$$\dots \ (15)$$

Here, $<S^{(m)}_{t-1,i}S^{(m)}_{t,j}>$ is a component in ith row and jth column of the posterior probability $<S^{(m)}_{t-1}S^{(m)}_{t}'>$ that is the matrix with K rows and K columns and indicates a state probability of being in the state #i at the point of time t-1 and being in the state #j of a next point of time t in the factor #m.

$<S^{(m)}_{t-1,i}>$ is a component in an ith row of a column vector posterior probability $<S^{(m)}_{t-1}>$ with K rows and indicates a state probability of being in the state #i of the factor #m at the point of time t-1.

$\pi^{(m)}$ ($\pi^{(m)new}$) is a column vector with K rows with (an updated value $\pi^{(m)}_{k}{}^{new}$ of) the initial state probability $\pi^{(m)}_{k}$ of the state #k of the factor #m being a kth component.

<Information Presentation Processing>

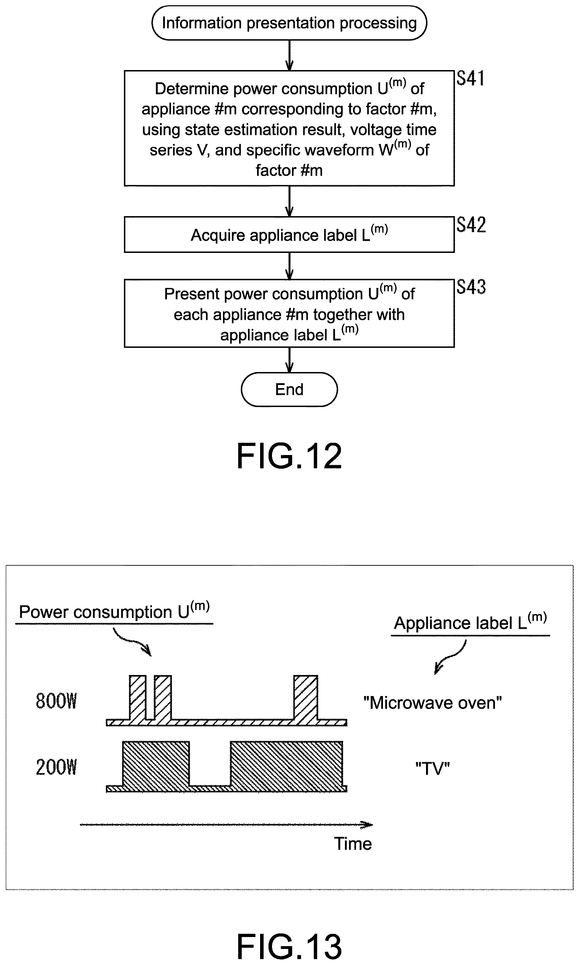

Fig. 12 is a flowchart describing an example of information presentation processing of presenting information of the appliance #m, which is performed by the disaggregation apparatus 16 (Fig. 5).

In Step S41, the data output unit 36 determines power consumption $U^{(m)}$ of each factor #m, using a voltage waveform $V_t$ (voltage waveform corresponding to the current waveform $Y_t$) from the data acquisition unit 31, the posterior probability $<S^{(m)}_t>$ that is the state estimation result from the state estimation unit 32, and the specific waveforms W(m) stored in the model storage unit 33. Then, the processing proceeds to Step S42.

Here, using the voltage waveform $V_t$ at the point of time t and current consumption At of the appliance #m corresponding to the factor #m at the point of time t, the data output unit 36 determines the power consumption $U_{(m)}$ of the appliance #m corresponding to the factor #m at the point of time t.

In the data output unit 36, the current consumption At of the appliance #m corresponding to the factor #m at the point of time t is determined in the following manner.

Specifically, the data output unit 36 determines a specific waveform $W^{(m)}$ of the state #k having a maximum posterior probability $<S^{(m)}_t>$ in the factor #m, for example, as the current consumption At of the appliance #m corresponding to the factor #m at the point of time t.

Further, the data output unit 36 determines a weighting addition value of specific waveforms $W^{(m)}_1$, $W^{(m)}_2$, ..., $W^{(m)}_K$ of each state of the factor #m, using the state probability of each state of the factor #m at the point of time t as a weight, which is a component of the posterior probability $<S^{(m)}_t>$ that is, for example, a column vector with K rows, as the current consumption At of the appliance #m corresponding to the factor #m at the point of time t.

Note that it is assumed that the learning of the FHMM progresses and the factor #m becomes an appliance model that suitably represents the appliance #m. In this case, regarding the state probability of each state of the factor #m at the point of time t, a state probability of a state corresponding to the operation state of the appliance #m at the point of time t is nearly 1 and a state probability of a K-1 number of remaining states is nearly 0.

As a result, in the factor #m, the specific waveform $W^{(m)}$ of the state #k having a maximum posterior probability $<S^{(m)}_t>$ is approximately identical to the weighting addition value of the specific waveforms $W^{(m)}_1$, $W^{(m)}_2$, ..., $W^{(m)}_k$ of each state of the factor #m, which uses as the state probability of each state of the factor #m at the point of time t as a weight.

In Step S42, the label acquisition unit 35 acquires an appliance #m indicated by each of the appliance models #m, i.e., an appliance label $L^{(m)}$ for identifying the appliance #m corresponding to each factor #m of the FHMM. The label acquisition unit 35 supplies it to the data output unit 36. Then, the processing proceeds to Step S43.

Here, in the label acquisition unit 35, for example, current consumption At of the appliance #m corresponding to each factor #m, which is determined by the data output unit 36, power consumption $U^{(m)}$, or a use time zone of the appliance #m, which is recognized on the basis of that power consumption $U^{(m)}$, is sent to the user's house from the communication unit 30 via the network 15. It can be presented to the user by the display device of the user's house displaying it.

Then, in the label acquisition unit 35, for example, the current consumption At or the power consumption $U^{(m)}$ presented to the user or the name of the appliance corresponding to the use time zone is input by the user and received via the network 15 and the communication unit 30. In this manner, the name of the appliance input by the user can be acquired as the appliance label $L^{(m)}$.

Further, in the label acquisition unit 35, for example, attributes regarding various appliances, such as power consumption thereof, current waveforms (current consumption), and use time zones can be associated with names of the appliances and registered as a database in advance. The name of the appliance that is, in such a database, associated with the current consumption At of the appliance #m corresponding to each factor #m that is determined by the data output unit 36, the power consumption $U^{(m)}$, and the use time zone of the appliance #m, which is recognized on the basis of the power consumption $U^{(m)}$, can be acquired as the appliance label $L^{(m)}$.

Note that, in the label acquisition unit 35, regarding the factor #m corresponding to the appliance #m whose the appliance label $L^{(m)}$ has already been acquired and supplied to the data output unit 36, the processing therefor of Step S42 can be skipped.

In Step S43, the data output unit 36 sends the power consumption $U^{(m)}$ of the appliance corresponding to each factor #m as well as the appliance label $L^{(m)}$ of that factor #m, to the user's house from the communication unit 30 via the network 15. It is presented to the user by the display device of the user's house displaying it, for example. Then, the information presentation processing is terminated.

Fig. 13 is a diagram showing a display example of the power consumption $U^{(m)}$ displayed by the display device of the user's house in the information presentation processing in Fig. 12.

In the display device, for example, as shown in Fig. 13, a time series of the power consumption $U^{(m)}$ of the appliance #m corresponding to each factor #m can be displayed together with the appliance label $L^{(m)}$ such as the name of the appliance #m.

In the disaggregation apparatus 16, the learning of the FHMM in which the operation states of each appliance are modeled using the FHMM in which each factor has three or more states is performed as the disaggregation. Thus, the power consumption or the like can be accurately determined with respect to a variable load appliance such as an air conditioner whose power consumption (current) varies according to a mode, settings, or the like.

Further, in the disaggregation apparatus 16, the power consumption of each appliance of the user's house can be determined only by measuring the total sum of currents, which is being consumed by the appliances of the user's house, at one point such as the distribution board 12. Therefore, "visualization" of the power consumption of each appliance of the user's house can be realized easily in terms of both of the cost and labor.

In accordance with the "visualization" of the power consumption of each appliance of the user's house as described above, it is possible to raise awareness for power saving in the user's house, for example.

Further, the disaggregation apparatus 16 is capable of collecting power consumption of appliances of many user's houses and estimating use time zones of the appliances, and thus life patterns, on the basis of the power consumption of each appliance of the user's houses. It can be useful for marketing and the like.

By the way, in order for the disaggregation apparatus 16 to perform disaggregation of determining current consumption or the like of the appliances of the user's house by the use of the current waveform $Y_t$ measured by the current sensor 13 in, the operation states of the appliances have to change and the current consumption of the appliances have to change.

The operation states of the appliances are changed by, for example, user's operations. However, it takes time to perform disaggregation when the operation states of the appliances are changed only by the user's operations.

Further, when the label acquisition unit 35 of the disaggregation apparatus 16 acquires the name of the appliance input by the user as the appliance label $L^{(m)}$, it is necessary for the user to input the name of the appliance that is the appliance label $L^{(m)}$. It may cause the user to feel troublesome.

In view of this, in the disaggregation system of Fig. 1, the agent 14 and the disaggregation apparatus 16 cooperatively operate. Thus, the operation states of the appliances are rapidly changed and the disaggregation is rapidly performed.

In addition, in the disaggregation system of Fig. 1, the agent 14 and the disaggregation apparatus 16 cooperatively operate, and hence, without causing the user to input (the name of the appliance that serves as) the appliance label $L^{(m)}$, the appliance label $L^{(m)}$ of the appliance corresponding to the factor #m is acquired and associated with the factor #m.

Hereinafter, as described above, the agent 14 and the disaggregation apparatus 16 that cooperatively operate will be described.

<Configuration Example of Agent 14>

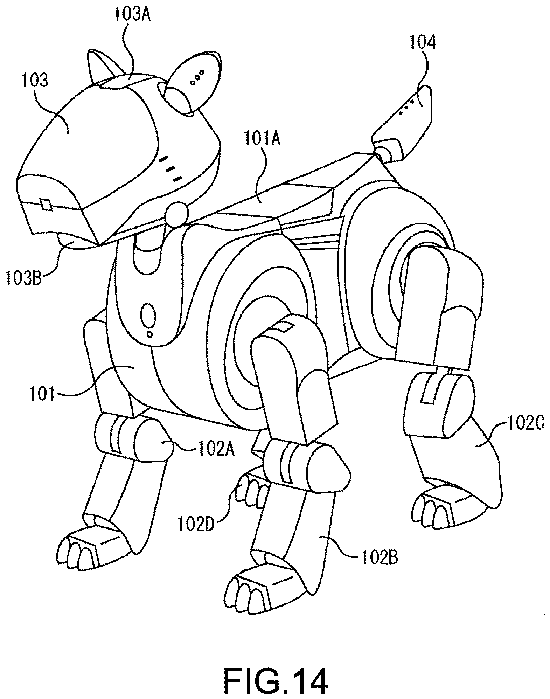

Fig. 14 is a perspective view showing an external configuration example of the agent 14 of Fig. 1.

In the embodiment of Fig. 14, the agent 14 is a pet robot which looks like a dog. Roughly speaking, the agent 14 is constituted of a body unit 1, leg units 102A, 102B, 102C, 102D, a head unit 103, and a tail unit 104.

To front, back, left, and right portions of the body unit 101 equivalent to a body, coupled are the leg units 102A, 102B, 102C, 102D equivalent to legs. To a front end portion and a back end portion of the body unit 101, coupled are the head unit 103 equivalent to a head and the tail unit 104 equivalent to a tail.

In an upper surface of the body unit 101, there is provided a back sensor 101A. Further, the head unit 103 includes a head sensor 103A at an upper portion thereof and a chin sensor 103B at a lower portion thereof. Note that the back sensor 101A, the head sensor 103A, and the chin sensor 103B are all constituted of pressure sensors and detect pressures applied to the sites.

The tail unit 104 is mounted on the body unit 101 so as to be swingable in a horizontal direction and a vertical direction.

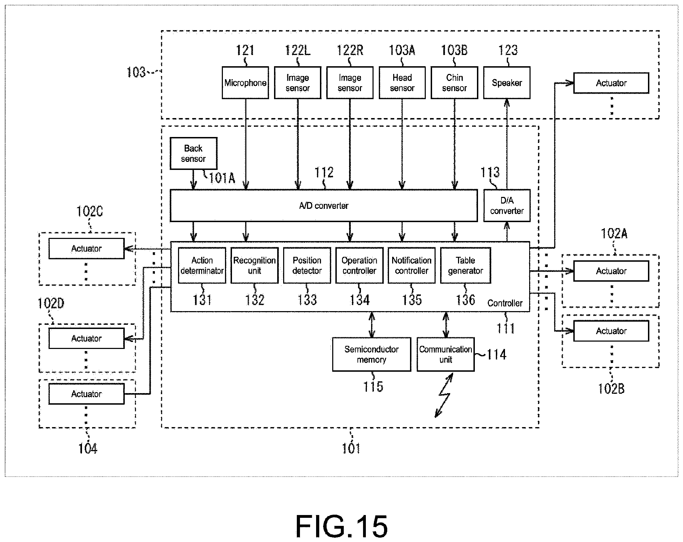

Fig. 15 is a block diagram showing an internal configuration example of the agent 14 of Fig. 14.

As shown in Fig. 15, a controller 111, an A/D (Analog/Digital) converter 112, a D/A converter 113, a communication unit 114, a semiconductor memory 115, the back sensor 101A, and the like are stored in the body unit 101.

The controller 111 performs overall control of the agent 14 and various types of processing.

The A/D converter 112 A/D-converts analog signals output by a microphone 121, CCD cameras 122L and 122R, the back sensor 101A, the head sensor 103A, and the chin sensor 103B into digital signals and supplies them to the controller 111. The D/A converter 113 D/A-converts digital signals supplied from the controller 111 into analog signals and supplies them to a speaker 123.

The communication unit 114 wirelessly or wiredly communicates with the outside. Specifically, the communication unit 114 receives data sent from the outside and supplies it to the controller 111. Further, the communication unit 114 sends data, which is supplied from the controller 111, to the outside.

The semiconductor memory 115 is constituted of, for example, a volatile memory such a RAM (Random Access Memory) or a nonvolatile memory such as an EEPROM (Electrically Erasable Programmable Read-only Memory). The semiconductor memory 115 stores an appliance table to be described later and other necessary data, for example, under the control of the controller 111.

Note that the semiconductor memory 115 can be configured to be attachable to or removable from a slot (not shown) provided in the body unit 101.

The back sensor 101A is provided at a site of the body unit 101, which corresponds to the back of the agent 14. The back sensor 101A detects a pressure from the user, which is applied thereto, and outputs a pressure detection signal corresponding to that pressure to the controller 111 via the A/D converter 112.

Note that, additionally, the body unit 101 also houses, for example, a battery (not shown) that is a power source of the agent 14 and a circuit that detects a residual quantity of the battery.

As shown in Fig. 15, the microphone 121, the image sensors 122L and 122R, the head sensor 103A, and the chin sensor 103B are provided in corresponding sites of the head unit 103, for example. The microphone 121 serves as a sensor that senses a stimulus from the outside, and is equivalent to the "ears" that sense sound. The image sensors 122L and 122R are equivalent to "left eye" and "right eye" that sense light. The head sensor 103A and the chin sensor 103B are equivalent to tactile sensations that sense pressures applied by a user's touch and the like. Further, the speaker 123 equivalent to the "mouth" of the agent 14 is placed at a corresponding site of the head unit 103, for example.

Actuators are installed in joints of the leg units 102A to 102D, coupling portions between the leg units 102A to 102D and the body unit 101, a coupling portion between the head unit 103 and the body unit 101, and a coupling portion between the tail unit 104 and the body unit 101, and the like. The actuator operates the respective parts on the basis of instructions from the controller 111. Specifically, the actuator moves, for example, the leg units 102A to 102D, such that the robot walks.

The microphone 121 installed in the head unit 103 collects surrounding voices (sound) including utterances from the user and outputs obtained audio signals to the controller 111 via the A/D converter 112. The image sensors 122L and 122R image surrounding circumstances and outputs obtained image signals to the controller 111 via the A/D converter 112. The head sensor 103A provided in an upper portion of the head unit 103 and the chin sensor 103B provided in a lower portion of the head unit 103 detect pressures received due to for example, a user's physical action, for example, "stroking" or "hitting" and output detection results thereof as pressure detection signals to the controller 111 via the A/D converter 112.

Here, in Fig. 15, the controller 111 includes an action determinator 131, a recognition unit 132, a position detector 133, an operation controller 134, a notification controller 135, and a table generator 136.

The action determinator 131 makes a determination as to the surrounding circumstances and the presence or absence of an instruction from the user and an action from the user, and the like on the basis of an audio signal, an image signal, a pressure detection signal, and the like provided from, for example, the microphone 121, the image sensors 122L and 122R, the back sensor 101A, the head sensor 103A, and the chin sensor 103B via the A/D converter 112. The action determinator 131 determines an action to be next taken by the agent 14 on the basis of a result of the determination. Then, the action determinator 131 drives the necessary actuator(s) on the basis of a result of the action determination. This causes the head unit 103 to swing in upper, lower, left, and right directions or moves the tail unit 104. Further, the action determinator 131 drives each of the leg units 102A to 102D such that the agent 14 takes an action of walking or operating the appliance of the user's house, for example.

Further, the action determinator 131 generates synthetic sound on the basis of the result of the action determination, and supplies it to the speaker 123 via the D/A converter 113 for outputting it or turns on, turns off, or blinks LEDs (Light Emitting Diodes) (not shown), which are provided at positions of the "eyes" of the agent 14.

As described above, the action determinator 131 causes the agent 14 to independently take an action on the basis of the surrounding circumstances, a user who tries to communicate with it, or the like.

The recognition unit 132 recognizes on the basis of, for example, image signals supplied to the controller 111 from the image sensors 122L and 122R via the A/D converter 112, an appliance set as an operation target for the agent 14 (hereinafter, also referred to as operation target appliance) and acquires an appliance label indicating the operation target appliance.

Specifically, the recognition unit 132 recognizes the operation target appliance on the basis of, for example, image signals of the operation target appliance, which are supplied from the image sensors 122L and 122R. The recognition unit 132 acquires information for identifying the operation target appliance, such as a model name and a model number, as the appliance label of the operation target appliance.

The model name, the model number, or the like that is the appliance label of the operation target appliance can be acquired by, for example, searching a server in the Internet for them and downloading them via the communication unit 114.

Otherwise, the model name, the model number, or the like that is the appliance label of the operation target appliance can be acquired by communicating with the operation target appliance via the communication unit 114.

Further, the recognition unit 132 recognizes an operation state of the operation target appliance on the basis of, for example, image signals of the operation target appliance, which are supplied from the image sensors 122L and 122R. The recognition unit 132 acquires an operation state label indicating the operation state.

Specifically, for example, when recognizing that the operation target appliance is powered OFF or ON as the operation state of the operation target appliance, the recognition unit 132 acquires character strings "power OFF" or "power ON", each indicating the fact that the power is turned OFF or ON, by generating it as the operation state label.

Further, for example, when recognizing that an operation mode of the operation target appliance is a power-saving mode as the operation state of the operation target appliance, the recognition unit 132 acquires the character string "power-saving mode" indicating the power-saving mode, by generating it as the operation state label.

Note that the recognition unit 132 is capable of recognizing the operation target appliance and the operation state of the operation target appliance by communicating with the operation target appliance via the communication unit 114, for example, other than the recognition on the basis of the image signal of the operation target appliance.

Further, the recognition 132 is capable of recognizing the operation target appliance and the operation state of the operation target appliance by asking the user for the operation target appliance and the operation state of the operation target appliance, for example.

Specifically, for example, the agent 14 asks the user for the operation target appliance and the operation state of the operation target appliance with synthetic sound or the like and recognizes an answer to the question as a user' voice. In this manner, the operation target appliance and the operation state of the operation target appliance can be recognized.

In this case, for example, a voice recognition result of the answer as the user' voice can be employed as the appliance label or the operation state label.

The position detector 133 detects the position of the operation target appliance by utilizing a GPS (Global Positioning System), for example. The position detector 133 outputs position information indicating that position.

For example, an absolute three-dimensional coordinate system can be defined and coordinates of the three-dimensional coordinate system can be employed as the position information of the operation target appliance. Further, for example, the agent 14 can acquire a map of the user's house by creating it, for example, and coordinates of a coordinate system with a predetermined position in the map being a reference or a location (e.g., living room, bedroom) in the map can be employed as the position information of the operation target appliance.

The operation controller 134 controls an operation made by the agent 14 with respect to the operation target appliance.

Specifically, the operation controller 134 determines which operation is to be performed on the operation target appliance and requests the action determinator 131 to perform the operation. The action determinator 131 determines an action of the agent 14 such that the operation according to the request of the operation controller 134 is performed, and drives the necessary actuator(s).

The disaggregation apparatus 16 is requested via the network 15 to detect an operation state of the appliance of the user's house. Then, the notification controller 135 acquires an operation state label indicating the operation state of the appliance of the user's house, which is sent from the disaggregation apparatus 16 in response to a request for detecting the operation state. Then, the notification controller 135 controls notification of the operation state of the appliance according to the operation state label.

Specifically, as will be described later, the disaggregation apparatus 16 sends, if necessary, the operation state label indicating the operation state of the appliance of the user's house, to the agent 14 via the network 15.

When the operation state label indicating the operation state of the appliance of the user's house is sent from the disaggregation apparatus 16, the notification controller 135 acquires the operation state label from the disaggregation apparatus 16 via the communication unit 114. Then, the notification controller 135 requests the action determinator 131 to notify of the operation state of the appliance according to the operation states label. According to the request of the operation controller 134, the action determinator 131 determines to output, for example, the operation state of the appliance as audio, generates synthetic sound for notifying of the operation state of the appliance, and causes the speaker 123 to output it via the D/A converter 113.

The table generator 136 associates the appliance label of the appliance (operation target appliance), which is obtained by the recognition unit 132, with the position of the appliance information obtained by the position detector 133. The table generator 136 registers them in the appliance table stored in the semiconductor memory 115.

Here, the appliance label and the position information of the appliance (operation target appliance), which are registered in the appliance table, are sent to the disaggregation apparatus 16 from the communication unit 114 via the network 15.

Further, under the control of the operation controller 134, the agent 14 operates the operation target appliance and the recognition unit 132 recognizes the operation state of the operation target appliance after the operation. When the operation state label of the operation state is acquired, the operation state label is sent to the disaggregation apparatus 16 from the communication unit 114 via the network 15.

Note that the operation controller 134 is capable of searching, for example, the server in the Internet for operation states that can be taken by the operation target appliance as the operation states thereof, and selecting, from among the operation states that can be taken by the operation target appliance, an operation state that should be taken by the operation target appliance, as an instruction operation state. In this case, the operation controller 134 is capable of controlling the operation with respect to the operation target appliance so as to obtain the instruction operation state. In addition, in this case, the recognition unit 132 is capable of recognizing the instruction operation state as the operation state of the operation target appliance.

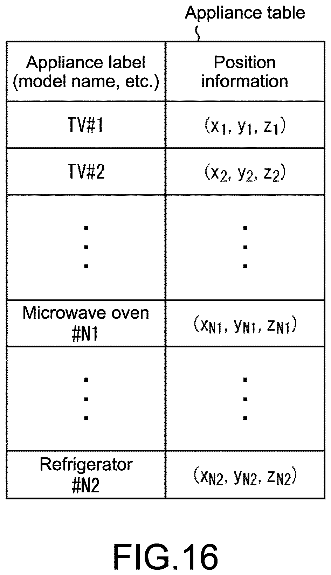

Fig. 16 is a diagram showing an example of the appliance table stored in the semiconductor memory 115 of Fig. 15.

In the appliance table, the appliance label of the appliance, which is obtained by the recognition unit 132, and the position of the appliance information, which is obtained by the position detector 133, are registered in association with each other.

The agent 14 independently moves in the user's house, for example. During movement, the recognition unit 132 recognizes an appliance on the basis of image signals supplied to the controller 111 from the image sensors 122L and 122R via the A/D converter 112. The recognition unit 132 selects that appliance as the candidate appliance that is a candidate of the operation target appliance.

In addition, the recognition unit 132 acquires the appliance label of the candidate appliance and causes the position information detector 133 to detect the position information of the candidate appliance. Then, the recognition unit 132 determines whether or not a set of appliance label and position information of the candidate appliance has been registered in the appliance table.

When the set of the appliance label and position information of the candidate appliance has been registered in the appliance table, the recognition unit 132 recognizes that the candidate appliance has already been selected as the operation target appliance. Then, the recognition unit 132 re-selects another appliance as the candidate appliance. Thereafter, similar processing is repeated.

On the other hand, when the set of the appliance label and position information of the candidate appliance has not been registered in the appliance table, the recognition unit 132 selects the candidate appliance as the operation target appliance. Then, the recognition unit 132 controls the table generator 136 to associate the appliance label of the operation target appliance (which had been the candidate appliance) with the position information and register them in the appliance table stored in the semiconductor memory 115.

<Configuration Example of Label Acquisition Unit 35>

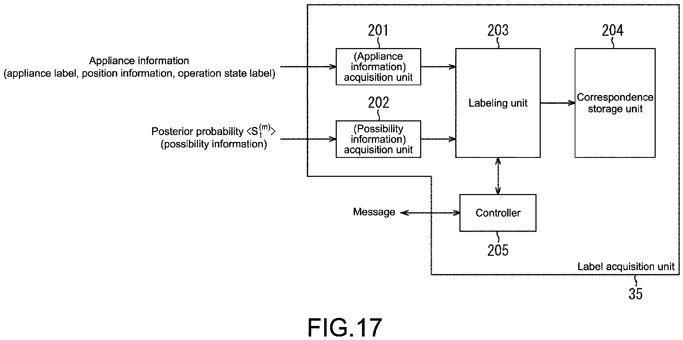

Fig. 17 is a block diagram showing a configuration example of the label acquisition unit 35 of Fig. 5 when the agent 14 and the disaggregation apparatus 16 cooperatively operate.

The label acquisition unit 35 includes acquisition units 201 and 202, a labeling unit 203, a correspondence storage unit 204, and a controller 205.

(Appliance Information) The acquisition unit 201 acquires appliance information of the operation target appliance, which is sent via the network 15 from the agent 14 and received by the communication unit 30 (Fig. 5). The acquisition unit 201 supplies it to the labeling unit 203.

Here, the appliance information of the operation target appliance is information on the operation target appliance. In this embodiment, the appliance information includes the appliance label, the position information, and the operation state label of the operation target appliance.

(Possibility Information) The acquisition unit 202 acquires a state probability (posterior probability) $<S^{(m)}{}_t>$ resulting from disaggregation using the current waveform $Y_t$ of the user's house, from (the estimator 42 of) the state estimation unit 32. The acquisition unit 202 supplies it to the labeling unit 203.

Here, it can be said that, in the disaggregation performed by the disaggregation apparatus 16, as described above, the specific waveform $W^{(m)}{}_k$ of each of the states #k of each factor #m, which is pattern information indicating current consumption in each of operation states of each of the appliances, is updated (determined) using the current waveform $Y_t$ that is the total sum data regarding the total sum of currents consumed by all the appliances of the user's house, such that the current consumption of the appliances is separated (the specific waveform $W^{(m)}{}_k$ is separated from the current waveform $Y_t$, as the current consumption in the operation state of the appliance #m corresponding to the state #k of the factor #m).

It can be said that, in updating of the specific waveform $W^{(m)}{}_k$ that is the pattern information, regarding the specific waveform $W^{(m)}{}_k$, the state probability $<S^{(m)}{}_t>$ that is the possibility information indicating a possibility that the current consumption indicated by the specific waveform $W^{(m)}{}_k$ is being consumed by the appliance #m corresponding to the factor #m is determined using the current waveform $Y_t$, and the specific waveform $W^{(m)}{}_k$ that is the pattern information is updated on the basis of the state probability $<S^{(m)}{}_t>$ that is the possibility information.

In the above-mentioned disaggregation, the acquisition unit 202 acquires, from the state estimation unit 32, a state probability $<S^{(m)}{}_t>$ that is the possibility information, which is obtained by the state estimation unit 32 with respect to (the state #k having) the specific waveform $W^{(m)}{}_k$.

The labeling unit 203 determines, on the basis of the state probability $<S^{(m)}{}_t>$ that is the possibility information from the acquisition unit 202, a specific waveform $W^{(m)}{}_k$ that is the pattern information indicating the current consumption consumed in the current operation state of the operation target appliance. The labeling unit 203 performs labeling of associating the appliance label and the operation state label of the operation target appliance, which are the appliance information from the acquisition unit 201, with (the state #k having) the specific waveform $W^{(m)}{}_k$.

Then, the labeling unit 203 registers the correspondence information resulting from the labeling, in the correspondence table stored in the correspondence storage unit 204.

The correspondence storage unit 204 stores the correspondence table.

The controller 205 monitors the labeling unit 203, for example. On the basis of a result of the monitoring, the controller 205 exchanges a necessary message with (the communication unit 114 of) the agent 14 via the communication unit 30 (Fig. 5) and the network 15.

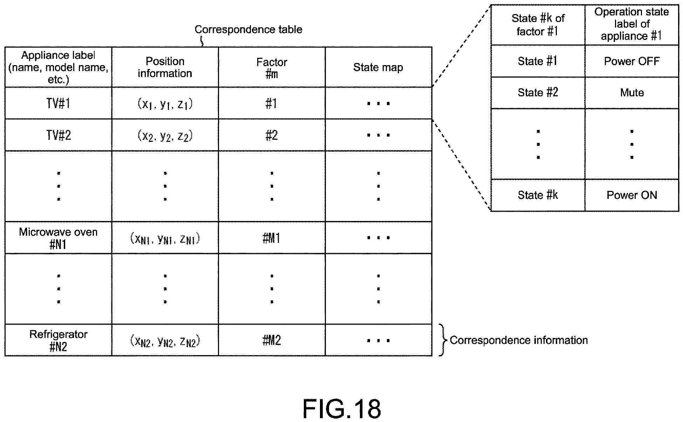

Fig. 18 is a diagram showing an example of the correspondence table stored in the correspondence storage unit 204 of Fig. 17.

The correspondence information is registered in the correspondence table.

With respect to the appliance of the user's house, the appliance label, the position information, and (a factor number #m as information for identifying) the factor #m corresponding to the appliance, and a state map are associated as the correspondence information.

In the state map, (a state number #k as information for identifying) the state #k of the factor #m corresponding to the appliance #m is associated with the operation state label of the operation state of the appliance #m.

Here, in accordance with the appliance label and the factor #m of the correspondence information, it is possible to recognize the factor #m corresponding to the appliance indicated by the appliance label and to recognize the appliance label of the appliance corresponding to the factor #m.

Further, in accordance with the appliance label and the state map of the correspondence information, it is possible to recognize the state #k of the factor #m corresponding to the operation state of the appliance indicated by the appliance label and to recognize the operation label of the operation state of the appliance corresponding to the state #k of the factor #m (the appliance corresponding to the factor #m).

Specifically, in the state map, the state #k of the factor #m corresponding to the appliance #m is associated with the operation state label of the operation state of that appliance #m. Therefore, the correspondence between the state #k of the factor #m and (the operation state label of) the operation state of the appliance corresponding to that factor #m can be recognized.

Here, the state #k of the factor #m has the specific waveform $W^{(m)}{}_k$ that is the pattern information. Therefore, it can be said that, in the state map, the operation state label of the operation state of the appliance #m in which a current indicated by the specific waveform $W^{(m)}{}_k$ is consumed is applied to the specific waveform $W^{(m)}{}_k$ that is the pattern information.

Further, in the correspondence information, the state map in which the above-mentioned operation state label is applied to (the state #k having) the specific waveform $W^{(m)}_k$ that is the pattern information is associated with the appliance label. Therefore, it can also be said that the appliance label of the appliance #m in which a current indicated by the specific waveform $W^{(m)}_k$ is being consumed is applied to the specific waveform $W^{(m)}_k$ that is the pattern information.

Therefore, it can be said that, in the correspondence information, the appliance label of the appliance in which a current indicated by the specific waveform $W^{(m)}_k$ is consumed and the operation state label of the operation state of that appliance are applied to the specific waveform $W^{(m)}_k$ that is the pattern information.

In accordance with the correspondence information, the appliance label of the appliance corresponding to the factor #m can be recognized. In addition, in accordance with the correspondence information, the operation state label of the operation state (of the appliance #m) corresponding to the state #k of the factor #m can be recognized.

<Labeling Processing>

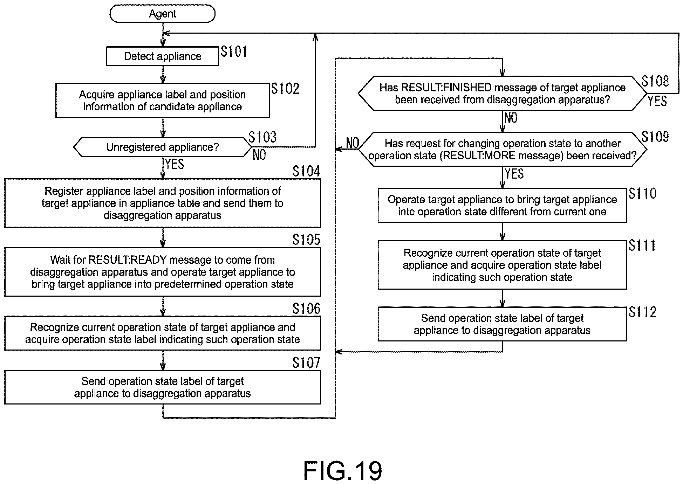

Fig. 19 is a flowchart showing an example of processing performed by the agent 14 of Fig. 15 as labeling processing for registering the correspondence information in the correspondence table.

In Step S101, the recognition unit 132 detects (recognizes) so-called appliances present in a field of view of the agent 14 on the basis of, for example, image signals supplied to the controller 111 from the image sensors 122L and 122R via the A/D converter 112. The recognition unit 132 selects any one of the appliances as the candidate appliance. Then, the processing proceeds to Step S102.

In Step S102, the recognition unit 132 generates (acquires) an appliance label of the candidate appliance, the position information detector 133 detects position information of the candidate appliance. Then, the processing proceeds to Step S103.

In Step S103, on the basis of the set of the appliance label and position information of the candidate appliance, the recognition unit 132 determines whether or not the candidate appliance is unregistered in the appliance table (Fig. 16).

When it is determined in Step S102 that the candidate appliance is not unregistered, i.e., when the set of the appliance label and position information of the candidate appliance has been already registered in the appliance table, the processing returns to Step S101 and similar processing is then repeated.

Further, when it is determined in Step S102 that the candidate appliance is unregistered, i.e., when the set of the appliance label and position information of the candidate appliance has not been registered in the appliance table, the processing proceeds to Step S104. Then, the recognition unit 132 selects the candidate appliance as the operation target appliance. Then, the recognition unit 132 controls the table generator 136 to register the appliance label and the position information of the operation target appliance in association with each other in the appliance table stored in the semiconductor memory 115.

In addition, in Step S104, the recognition unit 132 controls the communication unit 114 to send the appliance label and the position information of the operation target appliance to the disaggregation apparatus 16. Then, the processing proceeds to Step S105.

Here, the appliance label and the position information of the operation target appliance, which are sent from the communication unit 114 of the agent 14, are received by the communication unit 30 (Fig. 5) of the disaggregation apparatus 16 and supplied to the label acquisition unit 35 (Fig. 17), via the network 15.

In Step S105, the operation controller 134 waits for a RESULT:READY message to come from the disaggregation apparatus 16, and causes the agent 14 to operate the operation target appliance such that the operation target appliance is brought into a predetermined operation state (e.g., operation state in which the power is ON). Then, the processing proceeds to Step S106.

Here, the RESULT:READY message is a message indicating the fact that a preparation for registering the correspondence information in the correspondence table (Fig. 18) is completed in the label acquisition unit 35 of the disaggregation apparatus 16 (Fig. 17). The RESULT:READY message is sent to the agent 14 from the controller 205 of the label acquisition unit 35 via the communication unit 30 (Fig. 5) and the network 15. As described above, the RESULT:READY message sent to the agent 14 from the disaggregation apparatus 16 is received by the communication unit 114 and supplied to the operation controller 134.

In Step S106, the recognition unit 132 recognizes an operation state of the operation target appliance and generates (acquires) an operation state label indicating the operation state. Then, the processing proceeds to Step S107.

In Step S107, the recognition unit 132 controls the communication unit 114 to send the operation state label of the operation state of the operation target appliance to the disaggregation apparatus 16. Then, the processing proceeds to Step S108.

Here, the operation state of the operation target appliance label sent from the communication unit 114 of the agent 14 is received by the communication unit 30 (Fig. 5) of the disaggregation apparatus 16 and supplied to the label acquisition unit 35 (Fig. 17), via the network 15.

In Step S108, the operation controller 134 determines whether or not a RESULT:FINISHED message has been received from the disaggregation apparatus 16.

Here, the RESULT:FINISHED message is a message indicating the fact that the correspondence information of the operation target appliance has been registered in the correspondence table (Fig. 18) in the label acquisition unit 35 of the disaggregation apparatus 16 (Fig. 17). The RESULT:FINISHED message is sent to the agent 14 from the controller 205 of the label acquisition unit 35 via the communication unit 30 (Fig. 5) and the network 15.

In Step S108, whether or not the above-mentioned RESULT:FINISHED message has been sent from the disaggregation apparatus 16 and received by the communication unit 114 (Fig. 15) is determined.

When it is determined in Step S108 that the RESULT:FINISHED message has not been received, i.e., when the correspondence information of the operation target appliance has not been registered in the correspondence table in the label acquisition unit 35 of the disaggregation apparatus 16, the processing proceeds to Step S109. Then, the operation controller 134 determines whether or not a RESULT:MORE message has been received from the disaggregation apparatus 16.

Here, the RESULT:MORE message is a message for requesting to change the operation state of the operation target appliance to another operation state and is sent to the agent 14 from the controller 205 of the label acquisition unit 35 (Fig. 17) via the communication unit 30 (Fig. 5) and the network 15.

In Step S109, whether or not the above-mentioned RESULT:MORE message has been sent from the disaggregation apparatus 16 and received by the communication unit 114 (Fig. 15) is determined.

When it is determined in Step S109 that the RESULT:MORE message has not been received, the processing returns to Step S108 and similar processing is then repeated.

On the other hand, when it is determined in Step S109 that the RESULT:MORE message has been received, the processing proceeds to Step S110. Then, the operation controller 134 causes the agent 14 to operate the operation target appliance such that the operation target appliance is brought into an operation state different from the current operation state (e.g., such that the power supply transitions from an ON operation state to an OFF operation state). Then, the processing proceeds to Step S111.

In Step S111, the recognition unit 132 recognizes an operation state of the operation target appliance after the operation is made by the agent in Step S110, and generates (acquires) an operation state label indicating the operation state. Then, the processing proceeds to Step S112.

In Step S112, the recognition unit 132 controls the communication unit 114 to send the operation state label of the operation state of the operation target appliance after the operation is made by the agent in Step S110, to the disaggregation apparatus 16. Then, the processing returns to Step S108 and similar processing is then repeated.

Then, when it is determined in Step S108 that the RESULT:FINISHED message has been received, i.e., when the correspondence information of the operation target appliance has been registered in the correspondence table (Fig. 18) in the label acquisition unit 35 of the disaggregation apparatus 16, the processing returns to Step S101 and similar processing is then repeated.

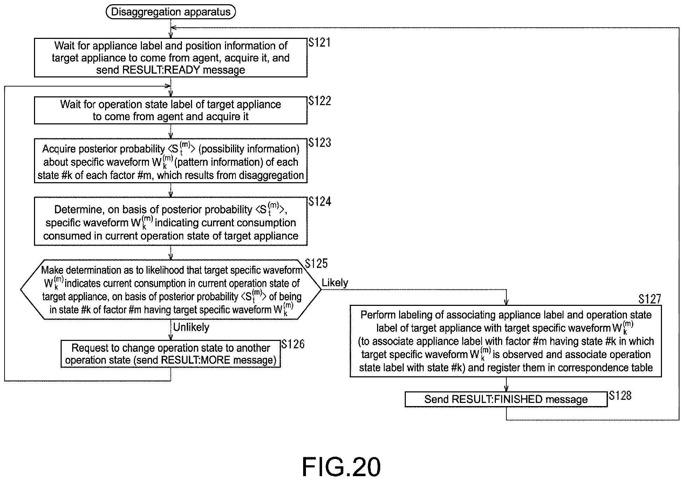

Fig. 20 is a flowchart showing an example of processing performed by the label acquisition unit 35 of the disaggregation apparatus 16 (Fig. 17) as labeling processing for registering the correspondence information in the correspondence table.

In Step S121, the acquisition unit 201 waits for the appliance label and the position information of the operation target appliance to come from the agent 14, and acquires the appliance label and the position information.

In other words, in Step S104 of Fig. 19, the agent 14 sends the appliance label and the position information of the operation target appliance. The appliance label and the position information of the operation target appliance from the agent 14 is received by the communication unit 30 of the disaggregation apparatus 16 (Fig. 5). Thus, the acquisition unit 201 acquires the appliance label and the position information of the operation target appliance, which have been received by the communication unit 30, and supplies them to the labeling unit 203.

When the appliance label and the position information of the operation target appliance are supplied to the labeling unit 203 from the acquisition unit 201, the controller 205 generates a RESULT:READY message indicating the fact that a preparation for registering the correspondence information in the correspondence table (Fig. 18) is completed. Then, the controller 205 sends it to the agent 14 from the communication unit 30 (Fig. 5). Then, the processing proceeds from Step S121 to Step S122.

In Step S122, the acquisition unit 201 waits for the operation state label of the operation state of the operation target appliance to come from the agent 14 and acquires the operation state label.

In other words, in Steps S107 and S122 of Fig. 19, the agent 14 sends the operation state label of the operation state of the operation target appliance. The operation state label of the operation state of the operation target appliance from the agent 14 is received by the communication unit 30 of the disaggregation apparatus 16 (Fig. 5). Thus, the acquisition unit 201 acquires the operation state label of the operation state of the operation target appliance, which has been received by the communication unit 30, and supplies it to the labeling unit 203.

After that, the processing proceeds from Step S122 to Step S123. The acquisition unit 202 acquires, from the state estimation unit 32 (Fig. 5), a state probability (posterior probability) $\langle S^{(m)}_t \rangle$ that is possibility information on specific

waveforms $W^{(m)}_k$ that are pattern information of the states #k of each factor #m, which results from disaggregation using the current waveform $Y_t$ of the user's house when the operation target appliance is in the current operation state. The acquisition unit 202 supplies it to the labeling unit 203. Then, the processing proceeds to Step S124.

In Step S124, the labeling unit 203 determines, on the basis of the state probability $<S^{(m)}_t>$ from the acquisition unit 202, a target specific waveform $W^{(m)}_k$ of the specific waveforms $W^{(m)}_k$ that are the pattern information of the states #k of each factor #m, the target specific waveform $W^{(m)}_k$ indicating the current consumption consumed in the current operation state of the operation target appliance. Then, the processing proceeds to Step S125.

Here, in Step S124, for example, a specific waveform (of the state #k of the factor #m), with respect to which the amount of increase of the state probability $<S^{(m)}_t>$ is largest among specific waveforms $W^{(1)}_1$, $W^{(1)}_2$, ..., $W^{(1)}_K$, $W^{(2)}_1$, $W^{(2)}_2$, ..., $W^{(1)}_K$, ...$W^{(M)}_1$, $W^{(M)}_2$, ..., $W^{(M)}_K$ of all the states #1 to #k of all the factors #1 to #M, as that before the operation state of the operation target appliance is changed is compared with that after the operation state is changed, can be determined as the target specific waveform $W^{(m)}_k$.

Note that, if the operation state of the operation target appliance has not ever been changed, for example, a specific waveform or the like with respect to which the state probability $<S^{(m)}_t>$ is lowest can be determined as the target specific waveform $W^{(m)}_k$.

In Step S125, on the basis of the state probability $<S^{(m)}_t>$ of the target specific waveform $W^{(m)}_k$, i.e., the state probability $<S^{(m)}_t>$ of the state #k of the factor #m having the target specific waveform $W^{(m)}_k$, the labeling unit 203 makes a determination as to a likelihood that the target specific waveform $W^{(m)}_k$ indicates current consumption in the current operation state of the operation target appliance.

In Step S125, for example, when the state probability $<S^{(m)}_t>$ of the target specific waveform $W^{(m)}_k$ is a probability equal to or larger than a threshold near 1.0 and smaller than 1.0, it is determined that the target specific waveform $W^{(m)}_k$ is likely. When the state probability $<S^{(m)}_t>$ of the target specific waveform $W^{(m)}_k$ is not the probability equal to or larger than the threshold, it is determined that the target specific waveform $W^{(m)}_k$ is unlikely.

When it is determined in Step S125 that the target specific waveform $W^{(m)}_k$ is unlikely, the processing proceeds to Step S126. Then, the controller 205 generates a RESULT:MORE message to change the operation state of the operation target appliance to another operation state in order to change the current consumption of the operation target appliance and send it to the agent 14 from the communication unit 30 (Fig. 5). Then, the processing returns from Step S126 to Step S122 and similar processing is then repeated.

On the other hand, when it is determined in Step S125 that the target specific waveform $W^{(m)}_k$ is likely, the processing proceeds to Step S127. The labeling unit 203 generates correspondence information (Fig. 18) in which the appliance label and the position information of the operation target appliance from the acquisition unit 201 and the operation state label are associated with the target specific waveform $W^{(m)}_k$.

Specifically, the labeling unit 203 sets the factor #m whose state #k has the target specific waveform $W^{(m)}_k$ to a corresponding factor #m corresponding to the operation target appliance. The labeling unit 203 associates (a factor number #m of) the corresponding factor #m with the appliance label and the position information of the operation target appliance and adds them to the correspondence information of the operation target appliance.

In addition, the labeling unit 203 sets the state #k of the corresponding factor #m having the target specific waveform $W^{(m)}_k$ to the corresponding state #k corresponding to the current operation state of the operation target appliance. The labeling unit 203 associates (a state number #k of) the corresponding state #k and the operation state label of the current operation state of the operation target appliance with the state map (Fig. 18) of the correspondence information of the operation target appliance and registers them.

Then, the labeling unit 203 registers the correspondence information of the operation target appliance in the correspondence table of the correspondence storage unit 204. Then, the processing proceeds to Step S128.

In Step S128, the controller 205 generates a RESULT:FINISHED message indicating the fact that the correspondence information of the operation target appliance has been registered in the correspondence table and causes the communication unit 30 (Fig. 5) to send it to the agent 14. Then, the processing returns from Step S128 to Step S121 and similar processing is then repeated.

As described above, in the agent 14 of the user's house, the operation target appliance is operated and the operation state of the operation target appliance is recognized. Then, the appliance label indicating the operation target appliance and the operation state label indicating the operation state of the operation target appliance are sent from the agent 14 to the disaggregation apparatus 16.

On the other hand, in the disaggregation apparatus 16, the operation target appliance label and the operation state label from the agent 14 are acquired and the state probability $<S^{(m)}_t>$ that is the possibility information that results from the disaggregation using the current waveform Y of the user's house is acquired. Then, in the disaggregation apparatus 16, the specific waveform $W^{(m)}_k$ that is the pattern information indicating the current consumption consumed in the current operation state of the operation target appliance is determined on the basis of the state probability $<S^{(m)}_t>$ that is that possibility information. The appliance label of the operation target appliance and the operation state label are associated with the specific waveform $W^{(m)}_k$ that is that pattern information.

Therefore, by the agent 14 operating the appliance, the current consumption of the appliance is changed. Thus, it is possible to rapidly perform disaggregation in the disaggregation apparatus 16 using the current waveform Y having that current consumption.

In addition, the agent 14 sends the appliance label indicating the appliance and the operation state label indicating the operation state of the appliance to the disaggregation apparatus 16. In the disaggregation apparatus 16, the appliance label and the operation state label are associated with the specific waveform $W^{(m)}_k$ that is the pattern information on the basis of the state probability $<S^{(m)}_t>$ that is the possibility information indicating a possibility that the current consumption indicated by the specific waveform $W^{(m)}_k$ that is the pattern information is being consumed. Thus, the operation state of each of the appliances of the user's house can be presented using the appliance label and the operation state label.

That is, in accordance with the appliance label and the operation state label, the appliance in which the current consumption indicated by the pattern information, with which the appliance label and the operation state label are associated, is being consumed and the operation state of that appliance can be presented in such a manner that a person can recognize them.

Note that the operation state of the operation target appliance can be independently changed in the agent 14 other than being changed according to the RESULT:MORE message sent to the agent 14 from the disaggregation apparatus 16. That is, the agent 14 is capable of independently taking an action of operating the operation target appliance so as to change the operation state of the operation target appliance.

<Configuration Example of Data Output Unit 36>

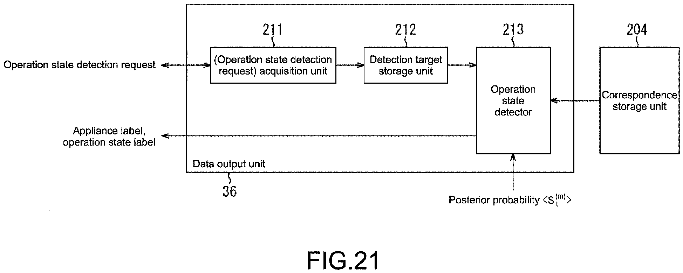

Fig. 21 is a block diagram showing a configuration example of the data output unit 36 of Fig. 5 when the agent 14 and the disaggregation apparatus 16 cooperatively operate.

The data output unit 36 includes an acquisition unit 211, a detection target storage unit 212, and an operation state detector 213.

(Operation State Detection Request) The acquisition unit 211 acquires an operation state detection request message for requesting to detect the operation state of the appliance, which is sent from the agent 14 via the network 15 and received by the communication unit 30 (Fig. 5), and supplies it to the detection target storage unit 212.

The detection target storage unit 212 stores a detection list that is a list for registering an appliance label of a detection target appliance that is an appliance set as a detection target of the operation state. The list is included in the operation state detection request message from the acquisition unit 211.

Here, the operation state detection request message sent by the agent 14 includes the appliance label of the detection target appliance.

The operation state detector 213 refers to the correspondence table (Fig. 18) stored in the correspondence storage unit 204 of the label acquisition unit 35. The operation state detector 213 detects the current operation state of the detection target appliance whose appliance label has been registered in the detection list stored in the detection target storage unit 212.

Specifically, the operation state detector 213 selects, from the correspondence table, the correspondence information including the appliance label stored in the detection target storage unit 212 as target correspondence information and acquires, from the state estimation unit 32, the state probability $<S^{(m)}_t>$ that is the possibility information of each state #k of the factor #m included in the target correspondence information.

In addition, the operation state detector 213 detects, on the basis of the state probability $<S^{(m)}_t>$ of each state #k of the factor #m, which is included in the target correspondence information, a state #k having a highest state probability $<S^{(m)}_t>$ among the states #k of the factors #m, which is included in that target correspondence information. The state #k is detected as a state corresponding to the current operation state of the detection target appliance.

Then, the operation state detector 213 causes the communication unit 30 (Fig. 5) to send an operation state label to the agent 14. The operation state label is associated with a state #k having a highest state probability $<S^{(m)}_t>$ in the state map of the target correspondence information. The operation state label is sent as a target operation state label indicating the current operation state of the detection target appliance. The operation state label is sent together with the appliance label of the detection target appliance.

<Operation State Notification Processing>

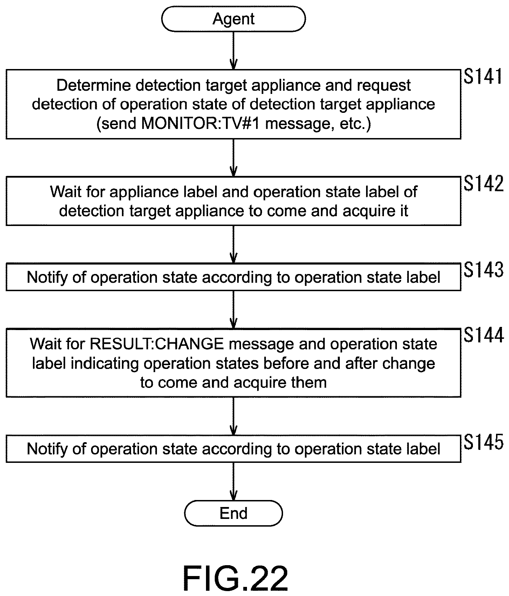

Fig. 22 is a flowchart showing an example of processing performed by the agent 14 of Fig. 15 as operation state notification processing of notifying the user of the operation states of the appliances of the user's house.

In Step S141, the notification controller 135 determines (an appliance that is set as) a detection target appliance from the appliances whose appliance labels have been registered in the appliance table stored in the semiconductor memory 115 (Fig. 16).

Here, in the notification controller 135, for example, one or more appliances whose operation state cannot be recognized by the agent 14 from a current location (e.g., appliances that cannot be captured by the image sensors 122L and 122R from the current location) among appliances whose appliance labels have been registered in the appliance table can be determined as detection target appliances.

The notification controller 135 includes the appliance label of the detection target appliance after determination of the detection target appliance. The notification controller 135 causes the communication unit 114 to send the operation state detection request message for requesting to detect the operation state of the detection target appliance to the disaggregation apparatus 16.

For example, when the appliance label of the detection target appliance is "TV#1," a MONITOR:TV#1 message that includes the appliance label and requests to detect the operation state of the detection target appliance is sent as the operation state detection request message.

The notification controller 135 waits for a RESULT:FINISHED message indicating the completion of reception of the request for detecting the operation state of the detection target appliance to come from the disaggregation apparatus 16 after the operation state detection request message is sent. The notification controller 135 acquires the RESULT:FINISHED message. Then, the processing proceeds from Step S141 to Step S142.

Specifically, the disaggregation apparatus 16 receives a operation state detection message from the agent 14 and sends the RESULT:FINISHED message to the agent 14. In the agent 14, the communication unit 114 receives the RESULT:FINISHED message from the disaggregation apparatus 16 and supplies it to the notification controller 135. The notification controller 135 acquires the RESULT:FINISHED message from the agent 14, which is supplied from the communication unit 114 in this manner.

In Step S142, the notification controller 135 waits for the appliance label and the operation state label of the detection target appliance to come from the disaggregation apparatus 16, and acquires the appliance label and the operation state label. Then, the processing proceeds to Step S143.

Specifically, the disaggregation apparatus 16 detects an operation state of the detection target appliance and sends the operation state label of the operation state together with the appliance label of the detection target appliance. In the agent 14, the communication unit 114 receives the appliance label and the operation state label of the detection target appliance from the disaggregation apparatus 16 and supplies it to the notification controller 135. Thus, the notification controller 135 acquires the appliance label and the operation state label of the detection target appliance, which is supplied from the communication unit 114 in this manner.

In Step S143, the notification controller 135 notifies, according to the operation state label acquired in Step S142, the user of the operation state of the detection target appliance of the appliance label, which is similarly acquired in Step S142. Then, the processing proceeds to Step S144.

Specifically, the notification controller 135 causes, for example, the agent 14 to output, as synthetic sound, a message indicating the fact that the detection target appliance of the appliance label is in the operation state indicated by the operation state label.

Alternatively, the notification controller 135 is capable of communicating with the display device out of the appliances of the user's house via the communication unit 114 and causing the display device to output the message indicating the fact that the detection target appliance of the appliance label is in the operation state indicated by the operation state label, as audio, and the screen to display it.

Otherwise, by performing communication with, for example, via the communication unit 114, the notification controller 135 is capable of sending the message indicating the fact that the detection target appliance of the appliance label is in the operation state indicated by the operation state label, to a portable terminal such as a smartphone possessed by the user. In this manner, it is possible to notify the user of the operation state of the detection target appliance.

In Step S144, the notification controller 135 waits for a RESULT:CHANGE message indicating the fact that the operation state of the detection target appliance has changed, the appliance label of the detection target appliance, and an operation state label indicating each of operation states before and after the change to come from the disaggregation apparatus 16. Then, the notification controller 135 acquires the RESULT:CHANGE message, the appliance label, and the operation state label. Then, the processing proceeds to Step S145.

Specifically, the disaggregation apparatus 16 detects an operation state of the detection target appliance. When the operation state changes, the disaggregation apparatus 16 sends the appliance label of the detection target appliance and an operation state label indicating each of the operation states before and after the change as well as the RESULT:CHANGE message. In the agent 14, the communication unit 114 receives the RESULT:CHANGE message from the disaggregation apparatus 16, the appliance label of the detection target appliance, and the operation state label indicating each of the operation states before and after the change and supplies them to the notification controller 135. Thus, the notification controller 135 acquires the RESULT:CHANGE message, the appliance label of the detection target appliance, and the operation state label indicating each of the operation states before and after the change, which are supplied from the communication unit 114 in this manner.

In Step S145, according to the operation state label acquired in Step S144, the notification controller 135 notifies the user of (the change in) the operation state of the detection target appliance of the appliance label similarly acquired in Step S144. Then, the processing is terminated.

Specifically, for example, it is assumed that the appliance label of the detection target appliance is "TV#1" indicating a certain TV, the operation state label indicating the operation state before the change indicates that the power is OFF, and the operation state label indicating the operation state after the change indicates that the power is ON. In this case, in the agent 14, for example, a message saying "TV#1 is powered ON." is generated and is output in the manner as described above with reference to Step S143. Thus, it is possible to notify the user of (the change in) the operation state of the detection target appliance.

Note that, in the disaggregation apparatus 16, the appliance label and the operation state label of the detection target appliance as well as the position information of that detection target appliance can also be sent to the agent 14.

In this case, in the agent 14, a message for notifying the user of (the change in) the operation state of the detection target appliance can be generated using the position information of the detection target appliance.

Specifically, for example, it is assumed that the appliance label of the detection target appliance is "TV#1" indicating a certain TV, the operation state label indicating the operation state before the change indicates the fact that the power is OFF, and the operation state label indicating the operation state after the change indicates the fact that the power is ON. In this case, if it can be, on the basis of the position information of the detection target appliance, recognized that the detection target appliance is placed in a living room of the user's house, the agent 14 is capable of generating a message saying "someone starts to watch TV#1 in the living", for example, using the position information of the detection target appliance.

Further, for example, it is assumed that the appliance label of the detection target appliance is a label indicating a certain lamp, the operation state label indicating the operation state before the change indicates the fact that the lamp is OFF, and the operation state label indicating the operation state after the change indicates the fact that the lamp is ON. In this case, if it can be, on the basis of the position information of the detection target appliance, recognized that a lamp that is a detection target appliance is placed in an entrance of the user's house, the agent 14 is capable of generating a message saying "light (lamp) in the entrance is turned on", for example, using the position information of the detection target appliance.

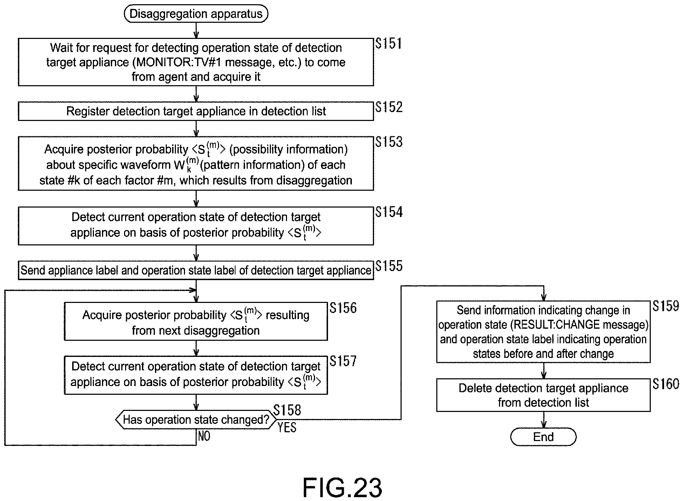

Fig. 23 is a flowchart showing an example of processing performed by the data output unit 36 (Fig. 21) of the disaggregation apparatus 16 as the operation state notification processing of notifying the user of the operation states of the appliances of the user's house.

In Step S151, the acquisition unit 211 waits for the operation state detection request message for requesting to detect the operation state of the detection target appliance to come from the agent 14 in Step S141 of Fig. 22. Then, the acquisition unit 211 acquires the operation state detection request message. Then, the processing proceeds to Step S152.

Specifically, the operation state detection request message sent by the agent 14 is received by the communication unit 30 of the disaggregation apparatus 16 (Fig. 5). Thus, the acquisition unit 211 acquires the operation state detection request message received by the communication unit 30.

In Step S152, the acquisition unit 211 supplies the appliance label of the detection target appliance, which is included in the operation state detection request message, to the detection target storage unit 212. Then, the acquisition unit 211 registers it in the detection list stored in the detection target storage unit 212.

Then, the acquisition unit 211 generates the RESULT:FINISHED message indicating the completion of reception of the request for detecting the operation state of the detection target appliance, and causes the communication unit 30 (Fig. 5) to send the agent 14. Then, the processing proceeds from Step S152 to Step S153.

In Step S153, the operation state detector 213 acquires a state probability (posterior probability) $<S^{(m)}_t>$ from the state estimation unit 32 (Fig. 5). The state probability (posterior probability) $<S^{(m)}_t>$ is the state probability (posterior probability) $<S^{(m)}_t>$ that is the possibility information on the specific waveform $W^{(m)}_k$ that is the pattern information of each of the states #k of each factor #m, which results from the disaggregation using the current waveform $Y_t$ of the user's house, which includes the current consumption of the detection target appliance whose appliance label has been registered in the detection list of the detection target storage unit 212. Then, the processing proceeds to Step S154.

In Step S154, the operation state detector 213 refers to the correspondence table (Fig. 18) stored in the correspondence storage unit 204. Then, the operation state detector 213 recognizes the factor #m associated with the appliance label of the detection target appliance, as the factor #m corresponding to the detection target appliance.

In addition, the operation state detector 213 refers to the correspondence table (Fig. 18) stored in the correspondence storage unit 204. The operation state detector 213 detects the current operation state of the detection target appliance on the basis of the state probability $<S^{(m)}_t>$ of each state #k of the factor #m corresponding to the detection target appliance out of the state probability $<S^{(m)}_t>$ acquired in Step S153.

Specifically, the operation state detector 213 detects, as the operation state of the detection target appliance, an operation state indicating an operation state label associated with a state #k having a highest state probability $<S^{(m)}_t>$ among the states #k of the factor #m corresponding to the detection target appliance in the state map associated with the appliance label of the detection target appliance of the correspondence table stored in the correspondence storage unit 204.

After that, the processing proceeds from Step S154 to Step S155 and the operation state detector 213 causes the communication unit 30 (Fig. 5) to send the appliance label and the operation state label of the detection target appliance (operation state label of the operation state detected in Step S154) to the agent 14. Then, the processing proceeds to Step S156.

Here, in Step S155, position information of the detection target appliance registered in the correspondence table (Fig. 18) in association with the appliance label of the detection target appliance can also be sent to the agent 14 together with the appliance label and the operation state label of the detection target appliance.

In Step S156, the operation state detector 213 waits for disaggregation in the user's house using the current waveform $Y_t$ at a next point of time t, which includes, for example, the current consumption of the detection target appliance, to be performed. The operation state detector 213 acquires the state probability (posterior probability) $<S^{(m)}_t>$ of each of the states #k of each factor #m, which results from the disaggregation, from the state estimation unit 32 (Fig. 5). Then, the processing proceeds to Step S157.

In Step S157, the operation state detector 213 detects a current operation state of the detection target appliance on the basis of the state probability $<S^{(m)}_t>$ as in Step S154. Then, the processing proceeds to Step S158.

In Step S158, the operation state detector 213 determines whether or not the operation state of the detection target appliance has changed (whether or not the latest result of the detection of the operation state about the detection target appliance and the previous result of the detection are different from each other).

When it is determined in Step S158 that the operation state of the detection target appliance has not changed, the processing returns to Step S156 and similar processing is then repeated.

Further, when it is determined in Step S158 that the operation state of the detection target appliance has changed, the processing proceeds to Step S159 and the operation state detector 213 causes the communication unit 30 (Fig. 5) to send, to the agent 14, the RESULT:CHANGE message indicating the fact that the operation state of the detection target appliance has changed, the appliance label of the detection target appliance, and the operation state label indicating each of the operation states before and after the change of the detection target appliance. Then, the processing proceeds to Step S160.

Here, in Step S159, position information of the detection target appliance registered in the correspondence table (Fig. 18) in association with the appliance label of the detection target appliance can also be sent to the agent 14 together with the RESULT:CHANGE message, the appliance label of the detection target appliance, and the operation state label.

In Step S160, the operation state detector 213 deletes, from the detection list of the detection target storage unit 212, the appliance label of the detection target appliance whose appliance label has been sent to the agent 14. Then, the processing is terminated.

Note that, when a plurality of appliance labels (of detection target appliances) have been registered in the detection list of the detection target storage unit 212, the processing in Step S153 to Step S160 are performed with respect to each of the detection target appliances indicated by the plurality of appliances labels.

As described above, the disaggregation apparatus 16 sends, to the agent 14, the operation state of the detection target appliance is detected on the basis of the state probability $<S^{(m)}_t>$ that is the possibility information and the appliance label and the operation state label of the detection target appliance. On the other hand, the agent 14 acquires the appliance label and the operation state label of the detection target appliance from the disaggregation apparatus 16. When the operation state of the detection target appliance indicated by the appliance label is notified according to the operation state label, the agent 14 is capable of recognizing an operation state of an appliance whose operation state cannot be recognized from a current location, for example (e.g., appliance that cannot be captured by the image sensors 122L and 122R from the current location) at once and notifying the user of it.

Note that all the appliances of the user's house (all the appliances whose appliance labels have been registered in the appliance table (Fig. 16)) are determined as detection target appliances in the agent 14, and hence the agent 14 is capable of recognizing the operation states of all the appliances of the user's house in real time.

Further, in this embodiment, the agent 14 presents the operation state of the detection target appliance according to the operation state of the detection target appliance label obtained from the disaggregation apparatus 16. However, alternatively, the agent 14 can take an action depending on the operation state of the detection target appliance according to the operation state of the detection target appliance label obtained from the disaggregation apparatus 16.

For example, when the detection target appliance is a porch lamp and the porch lamp transitions from OFF to ON, the agent 14 is capable of recognizing that the user comes back home and taking an action of moving to the entrance to greet the user.

Note that, although, in this embodiment, the movable agent 14 is employed as the control apparatus that controls the appliances of the user's house, an apparatus (e.g., a server in a home network) capable of controlling the power ON/OFF of the appliances, setting of (changes in) the operation modes, and the like through wireless communication or wired communication using the home network or the like can be employed as the control apparatus that controls the appliances other than a movable robot like the agent 14.

Further, in this embodiment, employed is the disaggregation of separating the current consumption of the appliances by determining (updating) the specific waveform $W^{(m)}_k$ by the use of the current waveform $Y_t$ that is the total sum data on the basis of the state probability $<S^{(m)}_t>$ indicating a possibility that the current consumption indicated by the specific waveform $W^{(m)}_k$ is being consumed, which is obtained with respect to the specific waveform $W^{(m)}_k$ indicating the current consumption of each operation state of each appliance. However, alternatively, for example, it is possible to employ disaggregation using arbitrary possibility information indicating a possibility that the current consumption indicated by the pattern information is being consumed other than the state probability $<S^{(m)}_t>$.

Specifically, for example, it is possible to employ disaggregation of separating the current consumption of the appliances by using an error between a predicted value of the total sum data (the current waveform $Y_t$) determined using the current consumption indicated by the pattern information as the possibility information and employing actual total sum data for updating the pattern information on the basis of that error such that the error is made smaller.

<Description of Computer to Which Present Technology is Applied>

Next, the above-mentioned series of processing of the agent 14 and the disaggregation apparatus 16 may be executed by hardware or may be executed by software. When the series of processing is executed by software, programs that configure the software are installed into a computer or the like.

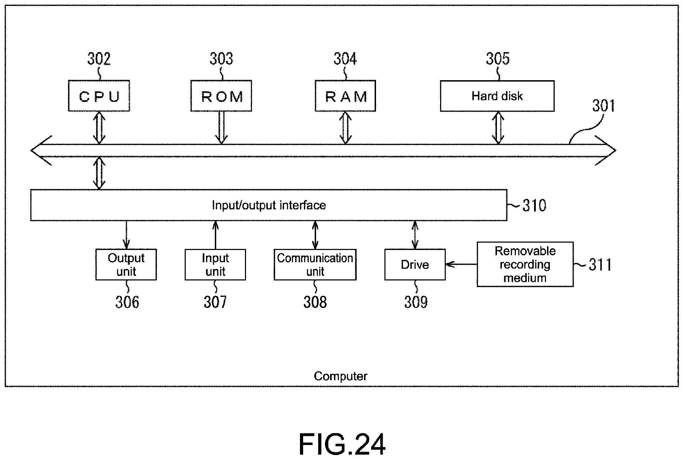

In view of this, Fig. 24 shows a configuration example of an embodiment of a computer in which a program for executing the above-mentioned series of processing is installed.

The programs can be in advance recorded on a hard disk 305 or a ROM 303 that is a built-in recording medium of the computer.

Alternatively, the program can be stored (recorded) in a removable recording medium 311. Such a removable recording medium 311 can be provided as so-called package software. Here, examples of the removable recording medium 311 includes a flexible disk, a CD-ROM (Compact Disc Read Only Memory), an MO (Magneto Optical) disc, a DVD (Digital Versatile Disc), a magnetic disk, and a semiconductor memory.

Note that, other than being installed in the computer from the above-mentioned removable recording medium 311, the program can be downloaded in the computer via a communication network or a broadcasting network and can be installed in the incorporated hard disk 305. Specifically, the program can be wirelessly transferred to the computer from a download site via an artificial satellite for digital satellite broadcasting, for example, and can be wiredly transferred to the computer via a network such as an LAN (Local Area Network) and the Internet.

The computer includes a built-in CPU (Central Processing Unit) 302. An input/output interface 310 is connected to the CPU 302 via a bus 301.

When an instruction is input by the user operating an input unit 307, for example, via the input/output interface 310, the CPU 302 accordingly executes the program stored in the ROM (Read Only Memory) 303. Alternatively, the CPU 302 loads the program stored in the hard disk 305 in a RAM (Random Access Memory) 304 and executes it.

With this, the CPU 302 performs the processing based on the above-mentioned flowcharts or the processing performed by the configurations of the above-mentioned block diagrams. Then, the CPU 302 causes an output unit 306 to output the result of processing or a communication unit 308 to send if necessary, via the input/output interface 310, for example, for recording it on the hard disk 305, for example.

Note that the input unit 307 is constituted of a keyboard, a mouse, a microphone, and the like. Further, the output unit 306 is constituted of an LCD (Liquid Crystal Display), a speaker, and the like.

Here, in the present specification, the processing performed by the computer according to the program does not necessarily need to be performed in a time series in the order described as each of the flowcharts. Specifically, the processing performed by the computer according to the program also includes processing (e.g., parallel processing or object processing) executed in parallel or individually.

Further, the program may be processed by a single computer (processor) or may be distributed and processed by a plurality of computers. In addition, the program may be transferred to a remote computer and executed.

Further, as used herein, the term "system" means a collection of a plurality of components (apparatuses, modules (parts), etc.). All the components may be housed in an identical casing or do not need to be housed in the identical casing. Therefore, a plurality of apparatuses housed in separate casings and connected to one another via a network and a single apparatus including a plurality of modules housed in a single casing are both the system.

Note that embodiments of the present technology are not limited to the above-mentioned embodiment and various modifications can be made without departing from the gist of the present technology.

For example, the present technology can take a cloud computing configuration in which a single function is distributed to a plurality of apparatuses via a network and processed by the plurality of apparatuses in a cooperative manner.

Further, the steps described above with reference to the flowcharts can be executed by a single apparatus and can also be distributed to a plurality of apparatuses and executed by the plurality of apparatuses.

In addition, when a single step includes a plurality of processes, the plurality of processes of the single step can be executed by a single apparatus and can also be distributed to a plurality of apparatuses and executed by the plurality of apparatuses.

Further, the effects described herein are merely examples and not limitative and other effects may be provided.

Note that the present technology can take the following configurations.

<1> An information processing apparatus, including:

an appliance information acquisition unit that acquires an appliance label and an operation state label from a control apparatus that

operates an appliance,
recognizes an operation state of the appliance, and
sends the appliance label indicating the appliance and the operation state label indicating the operation state of the appliance;

a possibility information acquisition unit that updates pattern information on the basis of possibility information indicating a possibility that current consumption indicated by the pattern information is being consumed, which is obtained with respect to the pattern information indicating the current consumption in each of operation states of each of a plurality of appliances, using total sum data on a total sum of currents consumed by the appliances, to thereby acquire the possibility information resulting from disaggregation of separating current consumption of the appliances; and
a labeling unit that determines, on the basis of the possibility information, pattern information indicating current consumption consumed in a current operation state of the appliance indicated by the appliance label, and performs labeling of associating the appliance label and the operation state label with the pattern information.

<2> The information processing apparatus according to <1>, in which
a likelihood that the pattern information indicates current consumption in the current operation state of the appliance indicated by the appliance label is determined on the basis of the possibility information, and
when the pattern information is unlikely, the control apparatus is requested to change the operation state of the appliance indicated by the appliance label to another operation state.

<3> The information processing apparatus according to <1> or <2>, further including
an operation state detector that detects the current operation state of the appliance on the basis of the possibility information, in which
the appliance label and the operation state label, which are associated with the pattern information indicating the current consumption consumed in the current operation state of the appliance, is sent to the control apparatus.

<4> The information processing apparatus according to <3>, in which
the appliance information acquisition unit also acquires position information indicating a position of the appliance,
the labeling unit also associates the appliance label and the operation state label as well as the position information with the pattern information, and
the position information is also sent to the control apparatus together with the appliance label and the operation state label, which are associated with the pattern information indicating the current consumption consumed in the current operation state of the appliance.

<5> The information processing apparatus according to any of <1> to <4>, in which
in the disaggregation,

state estimation in which a state probability of being in a state of each of factors of an FHMM (Factorial Hidden Markov Model) is determined as the possibility information is performed using the total sum data, and
learning of the FHMM is performed using the state probability.

<6> The information processing apparatus according to <5>, in which
the FHMM includes, as model parameters,

a specific waveform specific to each of states of each of the factors, which is used for determining a mean value of an observed value of the total sum data, which is observed in a combination of the states of the factors,

variance of the observed value of the total sum data, which is observed in the combination of the states of the factors,
an initial state probability that each of the states of each of the factors is an initial state,
a transition probability that each of the states of each of the factors transitions, and

in the learning of the FHMM, performed are

waveform separation learning in which the specific waveform is determined as the pattern information,
variance learning in which the variance is determined, and
state variation learning in which the initial state probability and the transition probability are determined.

<7> The information processing apparatus according to <6>, in which
in the state estimation,

an observation probability that the total sum data is observed in the combination of the states of the factors is determined using the mean value and the variance,
the total sum data $Y_1$, $Y_2$, ..., $Y_t$ is observed with respect to a sequence $Y_1$, $Y_2$, ..., $Y_T$ of the total sum data, using the observation probability and the transition probability, and a forward probability $\alpha_{t,z}$ of being in the combination z of the states of the factors at the point of time t and a backward probability $\beta_{t,z}$ of being the combination z of the states of the factors at the point of time t and then observing total sum data $Y_t$, $Y_{t+1}$, ..., $Y_T$ are determined,
a posterior probability $\gamma_{t,z}$ of being in the combination z of the states of the factors at the point of time t is determined using the forward probability $\alpha_{t,z}$ and the backward probability $\beta_{t,z}$, and
the state probability is determined by marginalizing the posterior probability $\gamma_{t,z}$.

<8> An information processing method, including the steps of:

acquiring an appliance label and an operation state label from a control apparatus that

operates an appliance,
recognizes an operation state of the appliance, and
sends the appliance label indicating the appliance and the operation state label indicating the operation state of the appliance;

updating pattern information, using total sum data on a total sum of currents consumed by a plurality of appliances, on the basis of possibility information indicating a possibility that current consumption indicated by the pattern information is being consumed, which is obtained with respect to the pattern information indicating current consumption in each of operation states of each of the appliances, to thereby acquire the possibility information resulting from disaggregation of separating current consumption of the appliances; and
determining, on the basis of the possibility information, pattern information indicating current consumption consumed in a current operation state of the appliance indicated by the appliance label and performing labeling in which the appliance label with the operation state label are associated with the pattern information.

<9> A program for causing a computer to function as:

an appliance information acquisition unit that acquires an appliance label and an operation state label from a control apparatus that

operates an appliance,
recognizes an operation state of the appliance, and
sends the appliance label indicating the appliance and the operation state label indicating the operation state of the appliance;

a possibility information acquisition unit that updates pattern information, on the basis of possibility information indicating a possibility that current consumption indicated by the pattern information is being consumed, which is obtained with respect to the pattern information indicating current consumption in each of operation states of each of a plurality of appliances, using total sum data on a total sum of currents consumed by the appliances, to thereby acquire the possibility information resulting from the disaggregation of separating current consumption of the appliances; and

a labeling unit that determines, on the basis of the possibility information, pattern information indicating current consumption consumed in a current operation state of the appliance indicated by the appliance label and performs labeling in which the appliance label and the operation state label are associated with the pattern information.

<10> A control apparatus, including:

an operation controller that controls an operation with respect to an appliance;

a recognition unit that recognizes an operation state of the appliance; and

a communication unit that updates pattern information on the basis of possibility information indicating a possibility that current consumption indicated by the pattern information is being consumed, which is obtained with respect to the pattern information indicating current consumption in each of operation states of each of a plurality of appliances, using total sum data on a total sum of currents consumed by the appliances, to thereby send, to a disaggregation apparatus that performs disaggregation of separating current consumption of the appliances, an appliance label indicating the appliance and an operation state label indicating the operation state of the appliance.

<11> The control apparatus according to <10>, which is a movable agent.

<12> The control apparatus according to <11>, in which

the operation controller controls, according to a request from the disaggregation apparatus, an operation with respect to the appliance to change the operation state of the appliance to another operation state.

<13> The control apparatus according to any of <10> to <12>, further including

a notification controller that acquires, in the disaggregation apparatus, an operation state label indicating the operation state of the appliance and the appliance label indicating the appliance, which are obtained on the basis of the possibility information, and controls, in accordance with the operation states label, notification of the operation state of the appliance indicated by the appliance label.

<14> The control apparatus according to <13>, in which

the recognition unit also recognizes a position of the appliance,

the communication unit also sends position information indicating the position of the appliance to the disaggregation apparatus, and

the notification controller controls, according to the operation state label and the position information, notification of the operation state of the appliance indicated by the appliance label.

<15> The control apparatus according to any of <10> to <14>, in which

the recognition unit recognizes the appliance and the operation state of the appliance by asking a user.

<16> A control method, including the steps of:

operating an appliance;

recognizing an operation state of the appliance; and

updating pattern information, using total sum data on a total sum of currents consumed by a plurality of appliances, on the basis of possibility information indicating a possibility that current consumption indicated by the pattern information is being consumed, which is obtained with respect to the pattern information indicating current consumption in each of operation states of each of the appliances, to thereby send, to a disaggregation apparatus that performs disaggregation of separating current consumption of the appliances, an appliance label indicating the appliance and an operation state label indicating the operation state of the appliance.

<17> A program for causing a computer to function as:

an operation controller that controls an operation with respect to an appliance;

a recognition unit that recognizes an operation state of the appliance; and

a communication unit that updates pattern information, using total sum data on a total sum of currents consumed by a plurality of appliances, on the basis of possibility information indicating a possibility that current consumption indicated by the pattern information is being consumed, which is obtained with respect to the pattern information indicating current consumption in each of operation states of each of the appliances, to thereby send, to a disaggregation apparatus that performs disaggregation of separating current consumption of the appliances, an appliance label indicating the appliance and an operation state label indicating the operation state of the appliance.

Description of Symbols

11 distribution board, 12 wattmeter, 13 current sensor, 14 agent, 15 network, 16 disaggregation apparatus, 30 communication unit, 31 data acquisition unit, 32 state estimation unit, 33 model storage
unit, 34 model learning unit, 35 label
acquisition unit, 36 data output unit, 41 evaluator, 42 estimator, 51 waveform
separation learning unit, 52 variance learning
unit, 53 state variation learning unit, 101 body unit, 101A back sensor, 102A to 102D leg unit, 103 head unit, 103A head sensor, 103B chin sensor, 104 tail unit, 111 controller, 112 A/D converter, 113 D/A
converter, 114 communication unit, 115 semiconductor memory, 121 microphone, 122L,
122R image sensor, 123 speaker, 131 action
determinator, 132 recognition unit, 133 position
detector, 134 operation controller, 135 notification controller, 136 table generator, 201, 202 acquisition unit, 203 labeling unit, 204 correspondence storage unit, 205 controller, 211 acquisition unit, 212 detection target
storage unit, 213 operation state detector, 301 bus, 302 CPU, 303 ROM, 304 RAM, 305 hard disk, 306 output unit, 307 input unit, 308 communication unit, 309 drive, 310 input/output interface, 311 removable recording
medium

**Claims**

**1.** An information processing apparatus, comprising:

an appliance information acquisition unit that acquires an appliance label and an operation state label from a control apparatus that

operates an appliance,
recognizes an operation state of the appliance, and
sends the appliance label indicating the appliance and the operation state label indicating the operation state of the appliance;

a possibility information acquisition unit that updates pattern information on the basis of possibility information indicating a possibility that current consumption indicated by the pattern information is being consumed, which is obtained with respect to the pattern information indicating the current consumption in each of operation states of each of a plurality of appliances, using total sum data on a total sum of currents consumed by the appliances, to thereby acquire the possibility information resulting from disaggregation of separating current consumption of the appliances; and
a labeling unit that determines, on the basis of the possibility information, pattern information indicating current consumption consumed in a current operation state of the appliance indicated by the appliance label, and performs labeling of associating the appliance label and the operation state label with the pattern information.

**2.** The information processing apparatus according to claim 1, wherein
a likelihood that the pattern information indicates current consumption in the current operation state of the appliance indicated by the appliance label is determined on the basis of the possibility information, and
when the pattern information is unlikely, the control apparatus is requested to change the operation state of the appliance indicated by the appliance label to another operation state.

**3.** The information processing apparatus according to claim 2, further comprising
an operation state detector that detects the current operation state of the appliance on the basis of the possibility information, wherein
the appliance label and the operation state label, which are associated with the pattern information indicating the current consumption consumed in the current operation state of the appliance, is sent to the control apparatus.

**4.** The information processing apparatus according to claim 3, wherein
the appliance information acquisition unit also acquires position information indicating a position of the appliance,
the labeling unit also associates the appliance label and the operation state label as well as the position information with the pattern information, and
the position information is also sent to the control apparatus together with the appliance label and the operation state label, which are associated with the pattern information indicating the current consumption consumed in the current operation state of the appliance.

5. The information processing apparatus according to claim 3, wherein
in the disaggregation,

state estimation in which a state probability of being in a state of each of factors of an FHMM (Factorial Hidden Markov Model) is determined as the possibility information is performed using the total sum data, and
learning of the FHMM is performed using the state probability.

6. The information processing apparatus according to claim 5, wherein
the FHMM includes, as model parameters,

a specific waveform specific to each of states of each of the factors, which is used for determining a mean value of an observed value of the total sum data, which is observed in a combination of the states of the factors,
variance of the observed value of the total sum data, which is observed in the combination of the states of the factors,
an initial state probability that each of the states of each of the factors is an initial state,
a transition probability that each of the states of each of the factors transitions, and

in the learning of the FHMM, performed are

waveform separation learning in which the specific waveform is determined as the pattern information,
variance learning in which the variance is determined, and
state variation learning in which the initial state probability and the transition probability are determined.

7. The information processing apparatus according to claim 6, wherein
in the state estimation,

an observation probability that the total sum data is observed in the combination of the states of the factors is determined using the mean value and the variance,
the total sum data $Y_1$, $Y_2$, ..., $Y_t$ is observed with respect to a sequence $Y_1$, $Y_2$, ..., $Y_T$ of the total sum data, using the observation probability and the transition probability, and a forward probability $\alpha_{t,z}$ of being in the combination z of the states of the factors at the point of time t and a backward probability $\beta_{t,z}$ of being the combination z of the states of the factors at the point of time t and then observing total sum data $Y_t$, $Y_{t+1}$, ..., $Y_T$ are determined,
a posterior probability $\gamma_{t,z}$ of being in the combination z of the states of the factors at the point of time t is determined using the forward probability $\alpha_{t,z}$ and the backward probability $\beta_{t,z}$, and
the state probability is determined by marginalizing the posterior probability $\gamma_{t,z}$.

8. An information processing method, comprising the steps of:

acquiring an appliance label and an operation state label from a control apparatus that

operates an appliance,
recognizes an operation state of the appliance, and
sends the appliance label indicating the appliance and the operation state label indicating the operation state of the appliance;

updating pattern information, using total sum data on a total sum of currents consumed by a plurality of appliances, on the basis of possibility information indicating a possibility that current consumption indicated by the pattern information is being consumed, which is obtained with respect to the pattern information indicating current consumption in each of operation states of each of the appliances, to thereby acquire the possibility information resulting from disaggregation of separating current consumption of the appliances; and
determining, on the basis of the possibility information, pattern information indicating current consumption consumed in a current operation state of the appliance indicated by the appliance label and performing labeling in which the appliance label with the operation state label are associated with the pattern information.

9. A program for causing a computer to function as:

an appliance information acquisition unit that acquires an appliance label and an operation state label from a control apparatus that

operates an appliance,
recognizes an operation state of the appliance, and
sends the appliance label indicating the appliance and the operation state label indicating the operation state of the appliance;

a possibility information acquisition unit that updates pattern information, on the basis of possibility information indicating a possibility that current consumption indicated by the pattern information is being consumed, which is obtained with respect to the pattern information indicating current consumption in each of operation states of each of a plurality of appliances, using total sum data on a total sum of currents consumed by the appliances, to thereby acquire the possibility information resulting from the disaggregation of separating current consumption of the appliances; and
a labeling unit that determines, on the basis of the possibility information, pattern information indicating current consumption consumed in a current operation state of the appliance indicated by the appliance label and performs labeling in which the appliance label and the operation state label are associated with the pattern information.

10. A control apparatus, comprising:

an operation controller that controls an operation with respect to an appliance;
a recognition unit that recognizes an operation state of the appliance; and
a communication unit that updates pattern information on the basis of possibility information indicating a possibility that current consumption indicated by the pattern information is being consumed, which is obtained with respect to the pattern information indicating current consumption in each of operation states of each of a plurality of appliances, using total sum data on a total sum of currents consumed by the appliances, to thereby send, to a disaggregation apparatus that performs disaggregation of separating current consumption of the appliances, an appliance label indicating the appliance and an operation state label indicating the operation state of the appliance.

11. The control apparatus according to claim 10, which is a movable agent.

12. The control apparatus according to claim 11, wherein
the operation controller controls, according to a request from the disaggregation apparatus, an operation with respect to the appliance to change the operation state of the appliance to another operation state.

13. The control apparatus according to claim 12, further comprising
a notification controller that acquires, in the disaggregation apparatus, an operation state label indicating the operation state of the appliance and the appliance label indicating the appliance, which are obtained on the basis of the possibility information, and controls, in accordance with the operation states label, notification of the operation state of the appliance indicated by the appliance label.

14. The control apparatus according to claim 13, wherein
the recognition unit also recognizes a position of the appliance,
the communication unit also sends position information indicating the position of the appliance to the disaggregation apparatus, and
the notification controller controls, according to the operation state label and the position information, notification of the operation state of the appliance indicated by the appliance label.

15. The control apparatus according to claim 12, wherein
the recognition unit recognizes the appliance and the operation state of the appliance by asking a user.

16. A control method, comprising the steps of:

operating an appliance;

recognizing an operation state of the appliance; and

updating pattern information, using total sum data on a total sum of currents consumed by a plurality of appliances, on the basis of possibility information indicating a possibility that current consumption indicated by the pattern information is being consumed, which is obtained with respect to the pattern information indicating current consumption in each of operation states of each of the appliances, to thereby send, to a disaggregation apparatus that performs disaggregation of separating current consumption of the appliances, an appliance label indicating the appliance and an operation state label indicating the operation state of the appliance.

17. A program for causing a computer to function as:

an operation controller that controls an operation with respect to an appliance;

a recognition unit that recognizes an operation state of the appliance; and

a communication unit that updates pattern information, using total sum data on a total sum of currents consumed by a plurality of appliances, on the basis of possibility information indicating a possibility that current consumption indicated by the pattern information is being consumed, which is obtained with respect to the pattern information indicating current consumption in each of operation states of each of the appliances, to thereby send, to a disaggregation apparatus that performs disaggregation of separating current consumption of the appliances, an appliance label indicating the appliance and an operation state label indicating the operation state of the appliance.

appliance label and the operation state label with the pattern information. The present technology is applicable to disaggregation of separating current consumption of appliances, for example.

FIG.1

FIG.2

FIG.3

FIG.4

FIG.5

A  Hidden Markov Model

B  Factorial Hidden Markov Model

FIG.6

FIG.7

Model learning using EM algorithm

Initialize — S11

Acquire measured waveforms $Y_1, Y_2, ..., Y_T$ — S12

E step — S13

M step — S14

NO — Converge? — S15

YES

End

# FIG.8

E step

Determine observation probability (evaluation value) $P(Y_t|S_t)$ that measured waveform $Y_t$ is observed in entire model $\phi$ | S21

Determine forward probability $\alpha_{t,z}$ of observing measured waveforms $Y_1, Y_2, ..., Y_t$ and being in combination z of states at point of time t in entire model $\phi$, using observation probability $P(Y_t|S_t)$ and transition probability $P_{i,j}^{(m)}$ | S22

Determine backward probability $\beta_{t,z}$ of being in combination z of states at point of time t and then observing measured waveforms $Y_t, Y_{t+1}, ..., Y_T$ in entire model $\phi$, using observation probability $P(Y_t|S_t)$ and transition probability $P_{i,j}^{(m)}$ | S23

Determine posterior probability $\gamma_{t,z}$ of being in combination z of states at point of time t in entire model $\phi$, using forward probability $\alpha_{t,z}$ and backward probability $\beta_{t,z}$ | S24

Determine, using posterior probability $\gamma_{t,z}$,
- posterior probability $\langle S_t^{(m)} \rangle$ of being state $S_t^{(m)}$ at point of time t in factor #m, and
- posterior probability $\langle S_t^{(m)} S_t^{(n)'} \rangle$ of being in state $S_t^{(m)}$ in factor #m and being in state $S_t^{(n)}$ in factor #n at point of time t | S25

Determine posterior probability $\langle S_{t-1}^{(m)} S_t^{(m)} \rangle$ of being in state $S_{t-1}^{(m)}$ at point of time t-1 in factor #m and being in state $S_t^{(m)}$ at next point of time t, using forward probability $\alpha_{t,z}$, backward probability $\beta_{t,z}$, transition probability $P(z|w)$, and observation probability $P(Y_t|S_t)$ | S26

Return

# FIG.9

FIG.10

M step

Determine updated value $W^{(m)new}$ of specific waveform $W^{(m)}$ using measured waveform $Y_t$ and posterior probabilities $\langle S_t^{(m)} \rangle$ and $\langle S_t^{(m)} S_t^{(n)'} \rangle$ (waveform separation learning)

S31

Determine updated value $C^{new}$ of variance $C$ using measured waveform $Y_t$, posterior probability $\langle S_t^{(m)} \rangle$, and specific waveform $W^{(m)}$ (variance learning)

S32

Determine updated value $P_{i,j}^{(m)new}$ of transition probability $P_{i,j}^{(m)}$ using posterior probabilities $\langle S_t^{(m)} \rangle$ and $\langle S_{t-1}^{(m)} S_t^{(m)'} \rangle$ and determine initial state probability using posterior probability $\langle S_t^{(m)} \rangle$ (state variation learning)

S33

Return

FIG.11

FIG.12

FIG.13

EP 3 174 004 A1

FIG.14

50

FIG.15

Appliance table

| Appliance label (model name, etc.) | Position information |
|---|---|
| TV#1 | $(x_1, y_1, z_1)$ |
| TV#2 | $(x_2, y_2, z_2)$ |
| ⋮ | ⋮ |
| Microwave oven #N1 | $(x_{N1}, y_{N1}, z_{N1})$ |
| ⋮ | ⋮ |
| Refrigerator #N2 | $(x_{N2}, y_{N2}, z_{N2})$ |

FIG.16

201
(Appliance information) acquisition unit

203
Labeling unit

204
Correspondence storage unit

Appliance information
(appliance label, position information, operation state label)

Posterior probability $\langle S_t^{(m)} \rangle$
(possibility information)

202
(Possibility information) acquisition unit

Message

Controller

205

Label acquisition unit

35

FIG.17

Correspondence table

| Appliance label (name, model name, etc.) | Position information | Factor #m | State map |
|---|---|---|---|
| TV#1 | $(x_1, y_1, z_1)$ | #1 | . . . |
| TV#2 | $(x_2, y_2, z_2)$ | #2 | . . . |
| . . . | . . . | . . . | . . . |
| Microwave oven #N1 | $(x_{N1}, y_{N1}, z_{N1})$ | #M1 | . . . |
| . . . | . . . | . . . | . . . |
| Refrigerator #N2 | $(x_{N2}, y_{N2}, z_{N2})$ | #M2 | . . . |

} Correspondence information

| State #k of factor #1 | Operation state label of appliance #1 |
|---|---|
| State #1 | Power OFF |
| State #2 | Mute |
| . . . | . . . |
| State #k | Power ON |

FIG.18

FIG.19

( Disaggregation apparatus )

S121 Wait for appliance label and position information of target appliance to come from agent, acquire it, and send RESULT:READY message

S122 Wait for operation state label of target appliance to come from agent and acquire it

S123 Acquire posterior probability $\langle S_t^{(m)} \rangle$ (possibility information) about specific waveform $W_k^{(m)}$ (pattern information) of each state #k of each factor #m, which results from disaggregation

S124 Determine, on basis of posterior probability $\langle S_t^{(m)} \rangle$, specific waveform $W_k^{(m)}$ indicating current consumption consumed in current operation state of target appliance

S125 Make determination as to likelihood that target specific waveform $W_k^{(m)}$ indicates current consumption in current operation state of target appliance, on basis of posterior probability $\langle S_t^{(m)} \rangle$ of being in state #k of factor #m having target specific waveform $W_k^{(m)}$

Likely

Unlikely

S126 Request to change operation state to another operation state (send RESULT:MORE message)

S127 Perform labeling of associating appliance label and operation state label of target appliance with target specific waveform $W_k^{(m)}$ (to associate appliance label with factor #m having state #k in which target specific waveform $W_k^{(m)}$ is observed and associate operation state label with state #k) and register them in correspondence table

S128 Send RESULT:FINISHED message

# FIG.20

FIG.21

```
        ⟨   Agent   ⟩
             │
             ▼
┌─────────────────────────────────────────────┐
│  Determine detection target appliance and request  │ S141
│  detection of operation state of detection target appliance │
│  (send MONITOR:TV#1 message, etc.)          │
└─────────────────────────────────────────────┘
             │
             ▼
┌─────────────────────────────────────────────┐
│  Wait for appliance label and operation state label of  │ S142
│  detection target appliance to come and acquire it  │
└─────────────────────────────────────────────┘
             │
             ▼
┌─────────────────────────────────────────────┐
│  Notify of operation state according to operation state label  │ S143
└─────────────────────────────────────────────┘
             │
             ▼
┌─────────────────────────────────────────────┐
│  Wait for RESULT:CHANGE message and operation state  │ S144
│  label indicating operation states before and after change  │
│  to come and acquire them                   │
└─────────────────────────────────────────────┘
             │
             ▼
┌─────────────────────────────────────────────┐
│  Notify of operation state according to operation state label  │ S145
└─────────────────────────────────────────────┘
             │
             ▼
         ⟨   End   ⟩
```

# FIG.22

Disaggregation apparatus

Wait for request for detecting operation state of detection target appliance (MONITOR:TV#1 message, etc.) to come from agent and acquire it | S151

Register detection target appliance in detection list | S152

Acquire posterior probability $\langle S_t^{(m)} \rangle$ (possibility information) about specific waveform $W_k^{(m)}$ (pattern information) of each state #k of each factor #m, which results from disaggregation | S153

Detect current operation state of detection target appliance on basis of posterior probability $\langle S_t^{(m)} \rangle$ | S154

Send appliance label and operation state label of detection target appliance | S155

Acquire posterior probability $\langle S_t^{(m)} \rangle$ resulting from next disaggregation | S156

Detect current operation state of detection target appliance on basis of posterior probability $\langle S_t^{(m)} \rangle$ | S157

Has operation state changed? | S158
NO
YES

Send information indicating change in operation state (RESULT:CHANGE message) and operation state label indicating operation states before and after change | S159

Delete detection target appliance from detection list | S160

End

FIG.23

59

FIG.24

## INTERNATIONAL SEARCH REPORT

| International application No. |
|---|
| PCT/JP2015/069828 |

**A. CLASSIFICATION OF SUBJECT MATTER**
*G06Q50/06*(2012.01)i, *G01R21/00*(2006.01)i, *G06Q10/00*(2012.01)i, *H02J13/00* (2006.01)i

According to International Patent Classification (IPC) or to both national classification and IPC

**B. FIELDS SEARCHED**

Minimum documentation searched (classification system followed by classification symbols)
G06Q50/06, G01R21/00, G06Q10/00, H02J13/00

Documentation searched other than minimum documentation to the extent that such documents are included in the fields searched
Jitsuyo Shinan Koho         1922-1996   Jitsuyo Shinan Toroku Koho   1996-2015
Kokai Jitsuyo Shinan Koho   1971-2015   Toroku Jitsuyo Shinan Koho   1994-2015

Electronic data base consulted during the international search (name of data base and, where practicable, search terms used)

**C. DOCUMENTS CONSIDERED TO BE RELEVANT**

| Category* | Citation of document, with indication, where appropriate, of the relevant passages | Relevant to claim No. |
|---|---|---|
| A | JP 2013-109742 A   (National Chiao Tung University), 06 June 2013 (06.06.2013), entire text; all drawings & US 2013/0132423 A1    & EP 2595098 A2 & TW 201321763 A         & CN 103135009 A & KR 10-1304724 B1 | 1-17 |
| A | JP 2013-44736 A   (Mitsubishi Electric Corp.), 04 March 2013 (04.03.2013), entire text; all drawings (Family: none) | 1-17 |

| ☒ | Further documents are listed in the continuation of Box C. | ☐ | See patent family annex. |
|---|---|---|---|

| \* | Special categories of cited documents: | "T" | later document published after the international filing date or priority date and not in conflict with the application but cited to understand the principle or theory underlying the invention |
|---|---|---|---|
| "A" | document defining the general state of the art which is not considered    to be of particular relevance | | |
| "E" | earlier application or patent but published on or after the international filing date | "X" | document of particular relevance; the claimed invention cannot be considered novel or cannot be considered to involve an inventive step when the document is taken alone |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search | Date of mailing of the international search report |
|---|---|
| 16 September 2015 (16.09.15) | 06 October 2015 (06.10.15) |

| Name and mailing address of the ISA/ Japan Patent Office 3-4-3,Kasumigaseki,Chiyoda-ku, Tokyo 100-8915,Japan | Authorized officer<br><br>Telephone No. |
|---|---|

Form PCT/ISA/210 (second sheet) (July 2009)

**INTERNATIONAL SEARCH REPORT**

International application No.

PCT/JP2015/069828

C (Continuation). DOCUMENTS CONSIDERED TO BE RELEVANT

| Category* | Citation of document, with indication, where appropriate, of the relevant passages | Relevant to claim No. |
|---|---|---|
| A | WO 2013/094687 A1 (Daiwa House Industry Co., Ltd.),<br>27 June 2013 (27.06.2013),<br>entire text; all drawings<br>& JP 2013-131148 A    & CN 104040568 A | 1-17 |
| A | JP 2012-138123 A (Mitsubishi Electric Corp.),<br>19 July 2012 (19.07.2012),<br>entire text; all drawings<br>(Family: none) | 1-17 |
| A | JP 2012-64023 A (Sony Corp.),<br>29 March 2012 (29.03.2012),<br>entire text; all drawings<br>& US 2012/0072141 A1   & US 2013/0275068 A1<br>& US 2015/0039254 A1 | 1-17 |
| A | JP 2013-45197 A (Sony Corp.),<br>04 March 2013 (04.03.2013),<br>entire text; all drawings<br>& US 2013/0054046 A1   & CN 102955900 A | 1-17 |
| A | JP 2013-218715 A (Informetis Corp.),<br>24 October 2013 (24.10.2013),<br>entire text; all drawings<br>(Family: none) | 1-17 |
| A | JP 2013-213825 A (Informetis Corp.),<br>17 October 2013 (17.10.2013),<br>entire text; all drawings<br>(Family: none) | 1-17 |
| A | US 2007/0268509 A1 (Jean-Marc Andreoll),<br>22 November 2007 (22.11.2007),<br>entire text; all drawings<br>(Family: none) | 1-17 |

Form PCT/ISA/210 (continuation of second sheet) (July 2009)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2013210755 A

**Non-patent literature cited in the description**

- **MICHAEL I. JORDAN.** Factorial Hidden Markov Models. *Machine Learning Volume,* November 1997, vol. 29 (2-3